# EUROPEAN PATENT SPECIFICATION

(11) **EP 3 971 897 B1**
(45) Date of publication and mention of the grant of the patent: **18.09.2024**
(21) Application number: 21819709.3
(22) Date of filing: 01.03.2021
(51) Int. Cl.: G11C 11/409, G11C 7/10, G06F 3/06, G11C 11/4091, G11C 11/4093, G11C 11/4097

(54) **SEMICONDUCTOR INTEGRATED CIRCUIT AND MEMORY**
INTEGRIERTE HALBLEITERSCHALTUNG UND SPEICHER
CIRCUIT INTÉGRÉ À SEMI-CONDUCTEURS ET MÉMOIRE

(30) Priority: 19.06.2020 CN 202010568039
(43) Date of publication of application: 23.03.2022
(73) Proprietor: Changxin Memory Technologies, Inc., Hefei, Anhui 230000 (CN)
(72) Inventor: SHANG, Weibing, Shanghai 200051 (CN); CHEN, Jixing, Shanghai 200051 (CN); WU, Xianjun, Shanghai 200051 (CN)
(74) Representative: Lavoix
(86) International application number: PCT/CN2021/078505
(87) International publication number: WO 2021/253870

(56) References cited:
- CN-A- 1 637 947
- CN-A- 101 952 957
- CN-A- 102 405 499
- CN-A- 104 051 008
- CN-U- 212 392 000
- US-A- 5 381 374
- US-A1- 2005 146 957
- US-A1- 2014 286 075
- US-A1- 2015 078 058
- US-A1- 2017 316 833
- US-B1- 6 208 575

## Description

### CROSS-REFERENCE TO RELATED APPLICATION

This application claims priority to Chinese Patent Application No.: 202010568039.9, entitled "SEMICONDUCTOR INTEGRATED CIRCUIT AND MEMORY" and filed on June 19, 2020.

### TECHNICAL FIELD

The present invention relates to the field of semiconductor technologies, and in particular, to a semiconductor integrated circuit and a memory.

### BACKGROUND

A dynamic random access memory (DRAM) is a semiconductor storage device commonly used in computing systems. The DRAM can include a plurality of repeating memory cells. Each memory cell can include a capacitor and a transistor. A gate of the transistor can be connected to a word line of the DRAM, a drain of the transistor can be connected to a bit line of the DRAM, and a source of the transistor can be connected to the capacitor. A voltage signal on the word line can turn ON or OFF the transistor. In this way, data stored in the capacitor can be read through the bit line. Alternatively, in some cases, data can be written into the capacitor for storage through the bit line.

A DRAM may be classified into various categories, such as a double data rate (DDR) DRAM, a graphics double data rate (GDDR) DRAM, and a low power double data rate (LPDDR) DRAM. As DRAMs are deployed to more technology fields, such as DRAM is more and more used in the mobile field, users may have higher requirements for DRAM data speed.

However, current data read and data write speeds of DRAMs need to be further improved.

US 6208575 B1 discloses a high performance dynamic memory array architecture and associated supporting circuitry.

US 2014/286075 A1 discloses a resistance change memory.

Patent applications US 2017/316833 A1, US 2005/146957 A1 and US 5381374 A also provide teachings related to the technical field of the application.

### SUMMARY

Embodiments of the present invention provide a semiconductor integrated circuit and a memory, to reduce the number of data lines.

The present invention is set out in the appended set of claims.

The semiconductor integrated circuit provided in an embodiment of the present invention is defined in claim 1.

In some implementations, the semiconductor integrated circuit can further include a reference data line (YIO#) configured to provide a reference signal (Ref) and an amplifier module configured to: receive a data signal of the second data line and the reference signal, amplify the data signal of the second data line, and output the amplified data signal of the second data line. The reference signal serves as a reference for amplifying the data signal of the second data line.

In some implementations, the reference data line can have fixed voltage potential.

In some implementations, the semiconductor integrated circuit can further include a reference module configured to output the reference signal to the reference data line in response to a read control signal. The reference module has a discharge capability that can cause voltage potential of the reference signal to gradually decrease during a data read operation.

In some implementations, during the data read operation, when the second data line is reduced from a first level to a second level, the local read-write conversion module has a first discharge speed; and during the data read operation, the reference module has a second discharge speed, and the second discharge speed is less than the first discharge speed.

In some implementations, the semiconductor integrated circuit can further include a reference control line configured to provide a reference control signal. The reference module is connected to the reference control line, and outputs the reference signal to the reference data line in response to the reference control signal and the read control signal.

In some implementations, the reference module comprises a first port, a second port, a third port, and a fourth port. The first port is configured to receive the read control signal, the second port is configured to connect to the reference data line, the third port is configured to be grounded, and the fourth port is configured to receive the reference control signal. The reference module is configured to discharge, in response to the reference control signal and the read control signal, from the second port to the third port, to cause the voltage potential of the reference data line to gradually decrease.

In some implementations, the reference module includes a first switch unit and a second switch unit. The first switch unit is connected between the first port and the third port and includes a first node, and the first switch unit is configured to be turned on in response to the read control signal to form a conductive path between the first node and the third port. The second switch unit is connected between the second port and the fourth port and includes a second node connected to the first node, and the second switch unit is configured to be turned on in response to the reference control signal to form a conductive path between the second port and the second node.

In some implementations, the reference module can include at least one reference transistor. A conductivity of the at least one reference transistor is weaker than a conductivity of the local read control transistor and a conductivity of the local read transmission transistor.

In some implementations, a channel width of the at least one reference transistor is less than channel widths of the local read control transistor and the local read transmission transistor.

In some implementations, the local read control transistor can be configured to be turned on in response to the read control signal. The local read transmission transistor can be configured to be turned on in response to the data signal of the first complementary data line, and the second data line is grounded through the local read transmission transistor and the local read control transistor. The at least one reference transistor can include a reference control transistor configured to be turned on in response to the read control signal, and the reference data line is grounded through the reference control transistor. A channel width of the reference control transistor can be less than a channel width of the local read control transistor.

In some implementations, the at least one reference transistor can further include a reference transmission transistor configured to be turned on in response to the reference control signal, and the reference data line is grounded through the reference control transistor and the reference transmission transistor. A channel width of the reference transmission transistor can be less than a channel width of the local read transmission transistor.

In some implementations, the channel width of the reference control transistor can be less than or equal to 2/3 of the channel width of the local read control transistor. The channel width of the reference transmission transistor can be less than or equal to 2/3 of the channel width of the local read transmission transistor.

In some implementations, the channel width of the reference control transistor can be 1/2 of the channel width of the local read control transistor. The channel width of the reference transmission transistor can be 1/2 of the channel width of the local read transmission transistor.

In some implementations, the amplifier module can include a differential amplifier. A first input end of the differential amplifier can be connected to the second data line and a second input end of the differential amplifier can be connected to the reference data line.

In some implementations, the semiconductor integrated circuit further includes a local amplifier module connected between the first data line and the first complementary data line. The local amplifier module can be configured to amplify the data signal of the first data line and the data signal of the first complementary data line.

In some implementations, the local amplifier module can include a first phase inverter and a second phase inverter. A first input end of the first phase inverter can be connected to the first data line and a first output end of the first phase inverter can be connected to the first complementary data line. A second input end of the second phase inverter can be connected to the first output end of the first phase inverter and the first complementary data line and a second output end of the second phase inverter can be connected to the first input end of the first phase inverter and the first data line.

An embodiment of the present invention further provides a memory defined in claim 13.

In some implementations, the plurality of sense amplifier arrays include: a plurality of first sense amplifier arrays disposed in odd columns and a plurality of second sense amplifier arrays disposed in even columns. A plurality of second data lines include a first group of data lines corresponding to the plurality of first sense amplifier arrays and a second group of data lines corresponding to the plurality of second sense amplifier arrays. The first group of data lines correspond to first data lines and first complementary data lines that are connected to the plurality of first sense amplifier arrays, and the second group of data lines correspond to first data lines and the first complementary data lines that are connected to the plurality of second sense amplifier arrays. A reference data line includes a first reference data line configured to provide a first reference signal and a second reference data line configured to provide a second reference signal. An amplifier module includes a first group of amplifier modules and a second group of amplifier modules. The first group of amplifier modules are configured to receive the first reference signal and data signals of the first group of data lines, and amplify the data signals of the first group of data lines. The second group of amplifier modules are configured to receive the second reference signal and data signals of the second group of data lines, and amplify the data signals of the second group of data lines.

In some implementations, the first group of amplifier modules correspond to the sense amplifier arrays in the odd columns, and the second group of amplifier modules correspond to the sense amplifier arrays in the even columns; and the first group of amplifier modules share the same first reference data line, and the second group of amplifier modules share the same second reference data line.

In some implementations, one half of the plurality of second data lines are located on one side of the first reference data line and the second reference data line, and the other half of the plurality of second data lines are located on the other side of the first reference data line and the second reference data line.

The technical solution provided in the embodiments of the invention has the following advantages.

The embodiments of the present invention provide a semiconductor integrated circuit, including: a first data line connected to a bit line through a column selection module and a first complementary data line connected to a complementary bit line through the column selection module, a second data line, and a reference data line; and a local read-write conversion module comprising a local read unit and a local write unit. The local read unit is configured to transmit a level of an inverted data signal of the first complementary data line to the second data line during a data read operation. Because there is no second complementary data line whose phase is opposite to that of the second data line during a read operation, a number of data lines used in the semiconductor integrated circuit is reduced, so that power consumption and a heat dissipation need are reduced, thereby improving electrical performance of the semiconductor integrated circuit.

During the data read operation, the local read-write conversion module has a first discharge speed. A reference module is configured to output a reference signal to the reference data line in response to a read control signal, where the reference signal serves as a reference for a data signal of the second data line, and during the data read operation, the reference module has a discharge characteristic, the reference module has a second discharge speed, and the second discharge speed is less than the first discharge speed. Because the reference module has a discharge characteristic, during the data read operation, when the second data line is read as 1, a potential difference between the data signal of the second data line and the reference signal gradually increases, so that a sense margin for reading 1 by the semiconductor integrated circuit gradually increases. When the second data line is read as 0, potential of both the data signal of the second data line and the reference signal gradually decreases, and because the second discharge speed is less than the first discharge speed, the potential of the data signal of the second data line decreases faster than the potential of the reference signal, so that a potential difference between the data signal of the second data line and the reference signal gradually increases, and therefore, a sense margin for reading 0 by the semiconductor integrated circuit gradually increases. Therefore, in the embodiments of the present invention, the sense margin for reading 0 and the sense margin for reading 1 may be basically consistent. In addition, both the sense margin for reading 0 and the sense margin for reading 1 can increase over time, which avoids a case that the sense margin for reading 1 does not change while the sense margin for reading 0 increases, so that read performance is improved.

In some embodiments, the semiconductor integrated circuit further includes the reference data line for providing a reference control signal, and a number of read control signals and reference control signals that the reference module responds to is the same as a number of control signals of a local read unit in the local read-write conversion module, so that a difference between the first discharge speed and the second discharge speed can be controlled by controlling a transistor performance difference, thereby further improving read performance.

### BRIEF DESCRIPTION OF THE DRAWINGS

FIG. 1 is a schematic diagram of functional modules of a semiconductor integrated circuit according to some embodiments of the present invention.
FIG. 2 is a schematic diagram illustrating a circuit structure of a local read-write conversion module in a semiconductor integrated circuit according to some embodiments of the present invention.
FIG. 3 is an equivalent circuit diagram when the amplifier module in FIG. 1 is a single-ended amplifier.
FIG. 4 is a schematic diagram illustrating a voltage potential change of a data signal of a second data line during a read operation according to some embodiments of the present invention.
FIG. 5 is a schematic diagram of functional modules of a semiconductor integrated circuit according to some other embodiments of the present invention.
FIG. 6 is a schematic diagram illustrating voltage potential changes of a second data line and a reference data line during a read operation according to some other embodiments of the present invention.
FIG. 7 is a schematic structural diagram of a semiconductor integrated circuit according to some other embodiments of the present invention.
FIG. 8 is a schematic structural diagram of a semiconductor integrated circuit according to some other embodiments of the present invention.
FIG. 9 is a schematic diagram illustrating voltage potential changes of a second data line and a reference data line during a read operation according to some other embodiments of the present invention.
FIG. 10 is a schematic diagram of a memory according to an embodiment of the present invention.
FIG. 11 is a partial schematic diagram of FIG. 10.

### DETAILED DESCRIPTION OF THE EMBODIMENTS

During a data read operation of a DRAM, upon a selected word line is activated, data is transmitted from a memory cell corresponding to the word line to a respective bit line. This transmission of the data from the memory cell to the bit line may cause a voltage on the bit line to slightly increase or decrease. A sense amplifier (i.e., a first sense amplifier) connected to the bit line may be configured to pull a signal on the bit line up to 1 or down to 0 depending on this slight signal. A column selection module can be configured to transmit a signal of 0 or 1 on a bit line to a local data line based on a column selection signal. The signal of the local data line may be further transmitted to a global data line through a semiconductor integrated circuit to complete the data read operation. During a data write operation of a DRAM, a transmission direction of the signal is opposite to that in the aforementioned data read operation. That is, the signal is transmitted through the global data line to the local data line, then the signal is transmitted to the bit line through the local data line, and then the signal is transmitted to the corresponding memory cell through the bit line, to complete the data write operation. It should be noted that 0 represents that the signal is at a low level, and 1 represents that the signal is at a high level.

A common signaling technique includes a dual-ended transmission or dual-phase transmission technique. In such a signaling technique, a local data line may include at least a pair of first data lines. One pair of first data lines is taken as an example, when one of the first data lines is at a high level, another first data line is at a low level during a data read operation or a data write operation. The global data line may include at least a pair of second data lines. One pair of second data lines is taken as an example, when one of the second data lines is at a high level, another second data line is at a low level during a data read operation or a data write operation. In this way, due to the contrast between the high level and the low level, when a second data line in the pair of the second data lines becomes high level, it may be quickly and accurately identified and defined that the second data line is at a high level.

However, for a DRAM operating in a dual-phase transmission manner, power consumption and a resistance of the DRAM may be high because the second data lines are in pairs and the number of second data lines in the memory is relatively large. Furthermore, heat dissipation through the data lines can be high and the large number of data lines can add complexity to routing and, in some cases, may affect performance of the DRAM.

The embodiments of the invention provide a semiconductor integrated circuit to partly solve the problems described above. Data of data lines associated with the semiconductor integrated circuit can be transmitted through a single-phase transmission manner such that the second data lines no longer appear in pairs. In this way, a number of the second data lines in the memory may be reduced, and the use of the data lines in the memory may be reduced by nearly half. For example, a semiconductor integrated circuit operating under a dual-ended transmission manner can comprise 2 times of 136 data lines (e.g., 136×2 = 272). By adopting a single-phase transmission manner, a number of data lines can be reduced from 272 to 136 (e.g., half of 272). In this way, various problems associated with a semiconductor integrated circuit with a large number of data lines, such as high power consumption, large resistance, heat dissipation, complex trace routing, etc. can be reduced. Therefore, the power consumption of the semiconductor integrated circuit, the heat dissipation requirement and the complexity of routing is reduced, thereby improving electrical performance of the semiconductor integrated circuit. The semiconductor integrated circuit provided by the embodiments of the invention will be described in detail below with reference to the accompanying drawings.

To make objectives, technical solutions, and advantages of the present invention clearer, the following disclosure describes various embodiments of the present invention in detail with reference to drawings. However, a person of ordinary skill in the art may understand that in the embodiments of the present invention, many technical details are proposed for readers to better understand the present invention. The technical solutions described in the present invention can be implemented even without these technical details, changes, and modifications made based on the following embodiments.

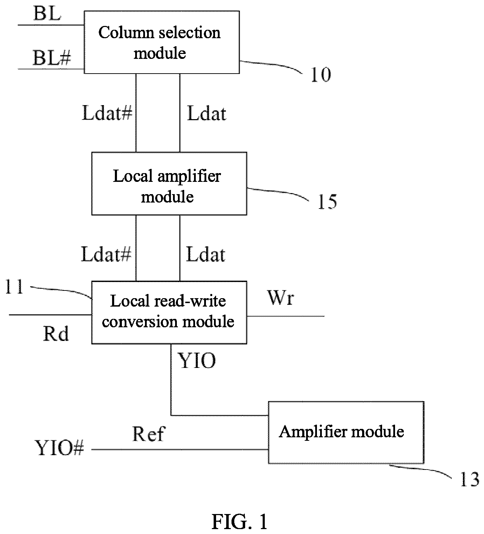

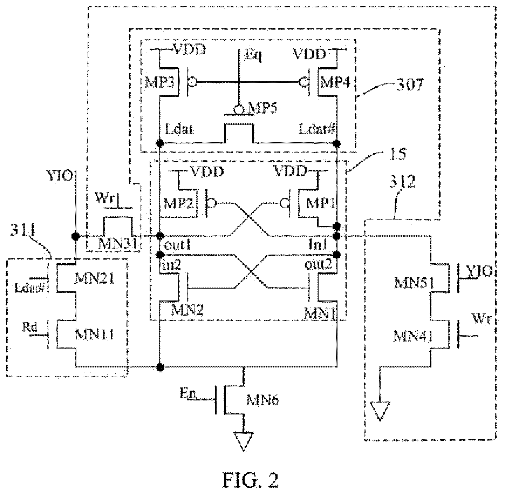

FIG. 1 is a schematic diagram of functional modules of a semiconductor integrated circuit according to some embodiments of the present invention. FIG. 2 is a schematic diagram illustrating a circuit structure of a local read-write conversion module in a semiconductor integrated circuit according to some embodiments of the present invention.

Referring to FIG. 1, in the embodiment, the semiconductor integrated circuit includes a first data line Ldat connected to a bit line BL through a column selection module 10, a first complementary data line Ldat# connected to a complementary bit line BL# through the column selection module 10, a second data line YIO, and a reference data line YIO#. The reference data line YIO# is configured to provide a reference signal. The semiconductor integrated circuit further includes a local read-write conversion module 11 and an amplifier module 13. The local read-write conversion module 11 is configured to perform, in response to a read or write control signal, data transmission between the first data line Ldat and the second data line YIO during a read-write operation. The amplifier module 13 is configured to receive a data signal of the second data line YIO and the reference signal, and amplify the data signal of the second data line YIO. The reference signal serves as a reference for amplifying the data signal of the second data line YIO.

The semiconductor integrated circuit provided in the embodiment will be described in detail below with reference to the accompanying drawings.

In the embodiment, the semiconductor integrated circuit includes at least a pair of the first data line Ldat and the first complementary data line Ldat#, that is, the first data line Ldat and the first complementary data line Ldat# can be complementary data lines. During a data read operation or a data write operation, a data signal of one of the first data line Ldat or the first complementary data line Ldat# is at a high level, and a data signal of the other data line is at a low level.

The first data line Ldat is a local data line, the first complementary data line Ldat# is a complementary local data line, and the second data line YIO is a global data line.

In an embodiment, the semiconductor integrated circuit is integrated into a memory. The memory includes a column selection module 10 and multiple memory cells. The column selection module 10 selects a memory cell for performing a data read operation or a data write operation. Correspondingly, a signal is transmitted between the bit line BL connected to the selected memory cell and the first data line Ldat, and a signal is transmitted between the complementary bit line BL# connected to the selected memory cell and the first complementary data line Ldat#.

The read-write control signal can include a read control signal Rd and a write control signal Wr. During a data read operation or a data write operation, the local read-write conversion module 11 transmits data of the first complementary data line Ldat# to the second data line YIO in response to the read control signal Rd; the local read-write conversion module 11 transmits data of the second data line YIO to the first data line Ldat in response to the write control signal Wr.

Referring to FIG. 1 and FIG. 2, in the embodiment, the local read-write conversion module 11 includes a local read unit 311 and a local write unit 312. The local read unit 311 is configured to transmit, in response to the read control signal Rd, a data signal of the first complementary data signal Ldat# to the second data line YIO during a data read operation. The local write unit 312 can be configured to transmit, in response to the write control signal Wr, a data signal of the second data line YIO to the first data line Ldat during a data write operation.

Referring to FIG. 2, the local read unit 311 includes a local read control transistor MN11 and a local read transmission transistor MN21. The local read control transistor MN11 can be configured to turn ON in response to the read control signal Rd, and a port of the local read control transistor MN11 is grounded. The local read transmission transistor MN21 can be configured to turn ON in response to the data signal of the first complementary data line Ldat#, such that the second data line YIO is grounded through the local read transmission transistor MN21 and the local read control transistor MN11. In a specific embodiment, a port of the local read control transistor MN11 may be directly grounded. In another specific embodiment, a port of the local read control transistor MN11 may be grounded through a switching transistor, that is, the port is grounded when the switching transistor is turned on, and the port is suspended when the switching transistor is turned off.

More specifically, a source of the local read control transistor MN11 is grounded, a drain of the local read control transistor MN11 is connected to a source of the local read transmission transistor MN21, and a drain of the local read transmission transistor MN21 is connected to the second data line YIO.

The local write unit 312 is configured to transmit, in response to the write control signal Wr, the data signal of the second data line YIO to the first data line Ldat during the data write operation.

Specifically, the local write unit 312 includes a first local write control transistor MN31, a second local write control transistor MN41, and a local write transmission transistor MN51. A gate of the first local write control transistor MN31 is configured to receive the write control signal Wr, a first port of the first local write control transistor MN31 is connected to the second data line YIO, and a second port of the first local write control transistor MN31 is connected to the first data line Ldat. A gate of the second local write control transistor MN41 is configured to receive the write control signal Wr, a first port of the second local write control transistor MN41 is grounded and a second port of the second local write control transistor MN41 is connected to a first port of the local write transmission transistor MN51. A gate of the local write transmission transistor MN51 is connected to the second data line YIO, and a second port of the local write transmission transistor MN51 is connected to the first complementary data line Ldat#.

The first local write control transistor MN31 is configured to electrically connect the second data line YIO to the first data line Ldat in response to the write control signal Wr. A source of the second local write control transistor MN41 is grounded and a drain of the second local write control transistor MN41 is connected to a source of the local write transmission transistor MN51.

The semiconductor integrated circuit further includes a local amplifier module 15. The local amplifier module 15 is connected between the first data line Ldat and the first complementary data line Ldat#, and configured to amplify data of the first data line Ldat and data of the first complementary data line Ldat#.

The local amplifier module 15 constitutes a circuit that amplifies a signal of the first data line Ldat and a signal of the first complementary data line Ldat#. In this way, the first data line Ldat and the first complementary data line Ldat# can be distinguished from one another more quickly, thereby improving a data transmission speed and data read-write speeds. In addition, because the data signals of the first data line Ldat and the first complementary data line Ldat# are amplified, the need for the first data line Ldat and the first complementary data line Ldat# to be driven by the first sense amplifier circuit of the memory can be reduced. Therefore, even if an area on the memory corresponding to the first sense amplifier circuit decreases, the first sense amplifier circuit still has sufficient drive capability to drive the first data line Ldat and the first complementary data line Ldat#. As such, the semiconductor integrated circuit can have better electrical performance while meeting the development trend of component miniaturization, thereby improving storage performance of the memory including the semiconductor integrated circuit.

Referring to FIG. 2, the local amplifier module 15 can include a first phase inverter 151 and a second phase inverter 152. A first input end in1 of the first phase inverter 151 can be electrically connected to the first data line Ldat and a first output end out1 of the first phase inverter 151 can be electrically connected to the first complementary data line Ldat#. A second input end in2 of the second phase inverter 152 can be electrically connected to the first output end out1 of the first phase inverter 151 and the first complementary data line Ldat#, and a second output end out2 of the second phase inverter 152 can be electrically connected to the first input end in1 of the first phase inverter 151 and the first data line Ldat.

The first phase inverter 151 can include a first Positive channel Metal-Oxide-Semiconductor (PMOS) transistor MP1 and a first Negative channel Metal-Oxide-Semiconductor (NMOS) transistor MN1. A gate of the first PMOS transistor MP1 and a gate of the first NMOS transistor MN1 can be electrically connected together and serve as the first input end in1 of the first phase inverter 151. A source of the first PMOS transistor MP1 can be connected to a supply voltage VDD. A drain of the first PMOS transistor MP1 and a drain of the first NMOS transistor MN1 can be connected together and serve as the first output end out 1 of the first phase inverter 151.

The second phase inverter 152 includes a second PMOS transistor MP2 and a second NMOS transistor MN2. A gate of the second PMOS transistor MP2 and a gate of the second NMOS transistor MN2 can be connected together and serve as the second input end in2 of the second phase inverter 152. A source of the second PMOS transistor MP2 can be connected to the supply voltage VDD. A drain of the second PMOS transistor MP2 and a drain of the second NMOS transistor MN2 can be connected together and serve as the second output end out2 of the second phase inverter 152.

The first PMOS transistor MP1, the first NMOS transistor MN1, the second PMOS transistor MP2, and the second NMOS transistor MN2 constitute the local amplifier module 15.

During a data read operation, because the local amplifier module 15, a transmission speed of data from the bit line BL to the first data line Ldat can be improved. Similarly, a transmission speed of data from the complementary bit line BL# to the first complementary data line Ldat# can also be improved. In this way, the need of using the first sense amplifier to drive data of the memory can be reduced.

For example, data of the bit line BL is at a high voltage and data of the complementary bit line BL# is at a low voltage. Because the first input end in1 of the first phase inverter 151 is connected to the second output end out2 of the second phase inverter 152, and the first output end out1 of the first phase inverter 151 is connected to the second input end in2 of the second phase inverter 152, when the data of the bit line BL and the data of the complementary bit line BL# are transmitted to the first data line Ldat and the first complementary data line Ldat#, respectively, a pull-up speed of the first data line Ldat is increased so that the first data line Ldat is pulled up to 1 quickly, and a pull-down speed of the first complementary data line Ldat# is also increased so that the first complementary data line Ldat# is pulled down to 0 quickly, thereby reducing the need of using the first sense amplifier to drive the first data line Ldat and the first complementary data line Ldat#.

Further, during a data read operation, the first data line Ldat is complementary to the first complementary data line Ldat#, in other words, when one of the first data line Ldat or the first complementary data line Ldat# is at a high level, the other data line is at a low level. Because of the local amplifier module 15, signals of the first data line Ldat and of the first complementary data line Ldat# are amplified. In this way, the difference between the first data line Ldat and the first complementary data line Ldat# can be increased more quickly and a transmission speed of data from the first data line Ldat and the first complementary data line Ldat# to the second data line YIO can be improved. For example, when the first data line Ldat is at a high level, the first complementary data line Ldat# is at a low level. In this example, when the first data line Ldat is at 1 and the first complementary data line Ldat# is at 0, data of the first data line Ldat and data of the first complementary data line Ldat# are transmitted to the second data line YIO. Because of the local amplifier module 15, the voltage of the first complementary data line Ldat# can approach to 0 V quicker, that is, the low level of the first complementary data line Ldat# is lower. In this way, the first data line Ldat and the first complementary data line Ldat# can be distinguished between each other quicker, and the speeds of the first data line Ldat and the first complementary data line Ldat# are improved to reach a large-signal mode. In this way, during a data read operation, data can be transmitted from the first data line Ldat and the first complementary data line Ldat# to the second data line YIO at higher speeds.

In some embodiments, the semiconductor integrated circuit further includes the enable NMOS transistor MN6. A gate of the enable NMOS transistor MN6 can receive an enable signal En. A source of the enable NMOS transistor MN6 can be connected to the ground. The first phase inverter and the second phase inverter can also be connected to a drain of the enable NMOS transistor MN6. Specifically, a source of the first NMOS transistor MN1 and a source of the second NMOS transistor MN2 are connected to the drain of the enable NMOS transistor MN6, and a port of the local read control transistor MN11 may be grounded through the enable NMOS transistor MN6.

In some embodiments, the semiconductor integrated circuit may further include a precharging module 307. The precharging module 307 can be connected between the first data line Ldat and the first complementary data line Ldat#. The precharging module 307 can be configured to precharge the first data line Ldat and the first complementary data line Ldat# line in response to a precharging control signal Eq.

Specifically, the precharging module 307 can include a third PMOS transistor MP3, a fourth PMOS transistor MP4, and a fifth PMOS transistor MP5. A gate of the third PMOS transistor MP3, a gate of the fourth PMOS transistor MP4, and a gate of the fifth PMOS transistor MP5 can receive the precharge control signal Eq. A source of the third PMOS transistor MP3 and a source of the fourth PMOS transistor MP4 can be connected to the supply voltage VDD. A drain of the third PMOS transistor MP3 can be electrically connected to the first data line Ldat. A drain of the fourth PMOS transistor MP4 can be connected to the first complementary data line Ldat#. The fifth PMOS transistor MP5 can be configured to connect the first data line Ldat to the first complementary data line Ldat# in response to the precharge control signal Eq.

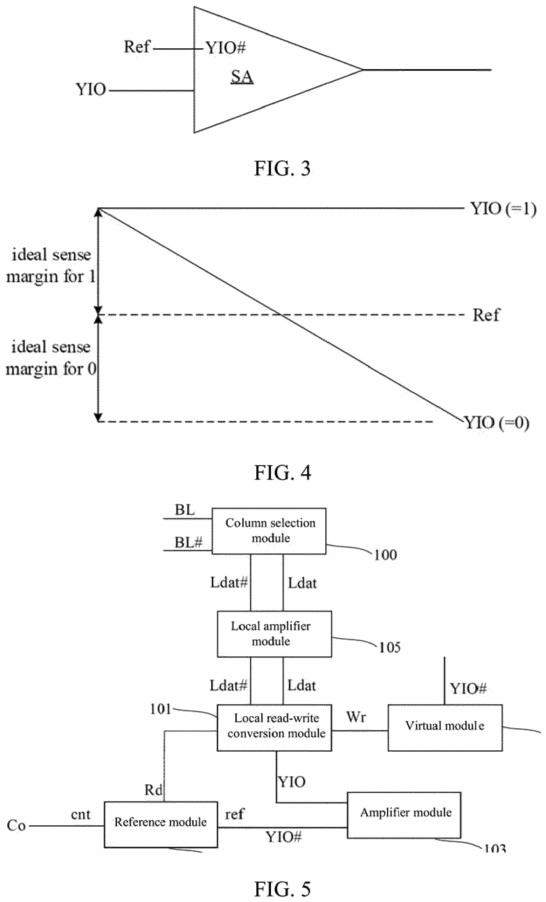

FIG. 3 is a schematic diagram of the amplifier module 13 according to an embodiment of the present invention.

Referring to FIG. 3, in the embodiment, in order to amplify the second data line YIO, the amplifier module 13 can be a single-ended amplifier SA with a fixed reference signal. That is to say, the reference data line YIO# has a fixed potential, and the reference signal is a signal with a fixed potential. The reference signal can serve as a reference for determining whether the second data line YIO has a binary value of 0 or 1. The reference signal can be used for sense 1 or sense 0.

In some embodiments, the reference data line YIO# can be built into the single-ended amplifier SA.

The semiconductor integrated circuit will be described in detail below in conjunction with the working mechanism of data read and write operations.

During a data read operation, the read control signal Rd is set to a high level. This causes the local read control transistor MN11 to turn ON. When the first complementary data line Ldat# is at a binary value of 0, the corresponding first data line is at a binary value of 1. Because the potential of the second data line YIO has been previously precharged to a high voltage, and the local read transmission transistor MN21 is not turned on, the second data line YIO remains at the high level (i.e., a binary value of 1).

During a data read operation, when the first complementary data line Ldat# is at a binary value of 1, the local read transmission transistor MN21 is turned ON. As such, a voltage potential of the second data line YIO is pulled down to 0 V. After receiving a data signal of the second data line YIO, the amplifier module 13 amplifies the data signal of the second data line YIO based on the reference signal and outputs an amplified data signal. In other words, the data signal of the second data line YIO outputted by the amplifier module 13 is 0 V. Specifically, in the process of pulling down the voltage potential of the second data line YIO, when the voltage potential of the second data line YIO is lower than a voltage potential of the reference signal by a certain threshold, the single-ended amplifier amplifies the data signal of the second data line YIO, in other words, the second data line YIO is pulled down to 0 V. The threshold may be determined by parameter characteristics of the single-ended amplifier SA.

FIG. 4 is a schematic diagram illustrating a voltage potential change of a data signal of the second data line during a data read operation in a solution using a single-ended amplifier according to an embodiment of the present invention. YIO(=0) can indicate a voltage potential of the second data line changing over time during the second data line changes to 0. YIO(=1) can indicate a voltage potential of the second data line changing over time during the second data line changes to 1 or remains at 1. Ref indicates a reference signal, ideal sense margin for 1 is an ideal sense margin for sense 1, ideal sense margin for 0 is an ideal sense margin for sense 0, the sense margin for sense 1 is an absolute value of a potential difference between YIO (=1) and Ref, and the sense margin for sense 0 is an absolute value of a potential difference between YIO (=0) and Ref.

Referring to FIG. 4, when the data signal of the second data line YIO changes to 1 or remains at 1, a voltage potential of the reference signal Ref is always lower than a voltage potential of the second data line YIO. Therefore, the data signal of the second data line amplified by the single-ended amplifier is 1. During the data signal of the second data line YIO changes to 0, a voltage potential of the second data line YIO gradually decreases, and when the voltage potential of the second data line YIO becomes lower than the voltage potential of the reference signal Ref, the data of the second data line YIO amplified by the single-ended amplifier is 0.

In the technical solution of the semiconductor integrated circuit provided herein, because data of the second data line is transmitted in a single-phase transmission manner, the second data line is no longer in pairs. Therefore, a second complementary data line whose phase is opposite to that of the second data line during a data read operation does not need to be disposed. Therefore, a number of data lines needed by the semiconductor integrated circuit can be significantly reduced. Correspondingly, power consumption of the semiconductor integrated circuit, heat generated by the data line, and the data line cabling difficulty can also be reduced.

In addition, because the amplifier module is a single-ended amplifier, the circuitry of the semiconductor integrated circuit can be simplified while maintaining the ability to amplify the data signal of the second data line.

A second embodiment of the present invention further provides a semiconductor integrated circuit. The semiconductor integrated circuit in this embodiment is basically the same as the semiconductor integrated circuit provided in the foregoing embodiment. The difference lies in that a reference signal provided by a reference data line serves as a reference for a second data line, and the reference signal is changing. Therefore, sense margins for sense 0 and sense 1 change over time, so that a read performance of the semiconductor integrated circuit during a data read operation is improved. The following describes in detail the semiconductor integrated circuit provided in the second embodiment of the present invention with reference to the accompanying drawings. For the parts the same as or corresponding to those in the foregoing embodiment, reference is made to the detailed descriptions in the foregoing embodiment, and details are omitted below for simplicity.

FIG. 5 is a schematic diagram of functional modules of a semiconductor integrated circuit according to some other embodiments of the present invention.

Referring to FIG. 5, in some embodiments, the semiconductor integrated circuit includes a first data line Ldat connected to a bit line BL through a column selection module 100, a first complementary data line Ldat# connected to a complementary bit line BL# through the column selection module 100, a second data line YIO, and a reference data line YIO#. The semiconductor integrated circuit further includes a local read-write conversion module 101, a reference module 102, and an amplifier module 103. The local read-write conversion module 101 is configured to perform, in response to a read or write control signal, data transmission between the first data line Ldat and the second data line YIO during a data read-write operation. The reference module 102 is configured to output a reference signal ref to the reference data line YIO# in response to a read control signal Rd. The reference signal ref can serve as a reference for a data signal of the second data line YIO. The reference module 102 can have a discharge characteristic during a data read operation, such that a voltage potential of the reference signal ref can gradually decrease. The amplifier module 103 is configured to receive the data signal of the second data line YIO and the reference signal ref, and amplify the data signal of the second data line YIO. The reference signal ref can serve as a reference for amplifying the data signal of the second data line YIO.

In some embodiments, the second data line YIO in the semiconductor integrated circuit can be a single bus. That is, a data signal of the second data line YIO can be transmitted in a single-ended transmission manner. Because of the reference module 102, a reference can be provided for determining whether the second data line YIO is at a binary value 1 or 0. During a data read operation, the process that the data signal of the second data line YIO changes from 1 to 0 is a discharge process. A discharge speed for which the reference module 102 discharges is less than a discharge speed of the read-write conversion module 101.

The semiconductor integrated circuit provided in the embodiment will be described in detail below with reference to the accompanying drawings.

During a data read operation, whether data of the second data line YIO is at a binary value 1 or 0 needs to be read in a timely and accurate manner. Through the reference module 102, the reference signal ref can be used as a reference for determining whether the data of the second data line YIO is at a binary value 1 or 0. It may be understood that the data of the second data line YIO being 1 or 0 means that the data of the second data line YIO amplified by the amplifier module 103 is 1 or 0.

In some embodiments, during a data read operation, when reading "1", the reference module 102 has a discharge characteristic, such that a voltage potential of the reference signal ref decreases gradually. As such, during a data read operation, when the data of the second data line YIO is 1, a voltage potential difference between the second data line YIO and the reference signal ref is no longer fixed but changes over time. During the data read operation, when the second data line YIO changes from a binary value of 1 to a binary value of 0, the voltage potential difference between the second data line YIO and the reference signal ref changes over time. Therefore, in such embodiments, sense margins for sense 0 and sense 1 change over time. In this way, the read accuracy of a read operation can be further improved.

In some embodiments, during a data read operation, when reading "0", in the process that a voltage potential of the second data line YIO decrease from a first level to a second level (that is, in the process that the second data line YIO changes from 1 to 0, where the first level ("1") may be generated in the process of precharging to a high level), the local read-write conversion module 101 has a first discharge speed. During a read operation, the reference module 102 has a second discharge speed, and the second discharge speed is less than the first discharge speed. In this way, it is ensured that the voltage potential of the reference signal ref is always higher than the voltage potential of the data signal of the second data line YIO in the process that the second data line YIO is reduced from the first level to the second level during the read operation. The accuracy of amplifying the second data line YIO by the amplifier module 103 in the process that the second data line YIO changes from 1 to 0 can be further improved. The reason is that, if the voltage potential of the reference signal is lower than the voltage potential of the second data line when the second data line changes from 1 to 0, and if the second data line is amplified in this case, the second data line is incorrectly amplified to 1, but the second data line is actually 0.

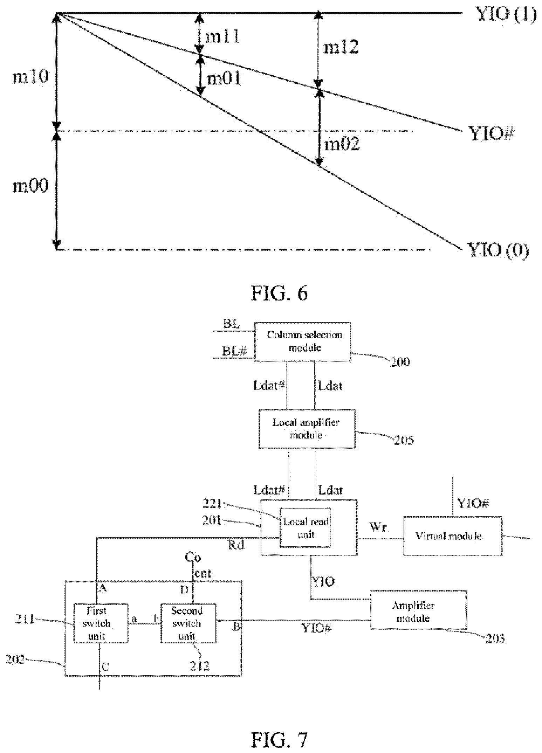

FIG. 6 is a diagram of voltage potential changes of the second data line YIO and the reference data line YIO# during a data read operation. YIO (1) indicates a voltage potential change when reading a binary value of 1 on the second data line YIO. YIO (0) indicates a voltage potential change when reading a binary value of 0 on the second data line YIO. YIO# indicates a voltage potential change of the reference data line. The semiconductor integrated circuit will be described in detail below in conjunction with the working mechanism of the semiconductor integrated circuit.

Referring to FIG. 6, for cases where the second data line YIO needs to be read as 1, that is, for sense 1, the second data line YIO needs to remain at 1 or change to 1. Because the reference module 102 has discharge performance, the voltage potential of the reference signal ref gradually decreases, and therefore, a sense margin for sense 1 increases over time. For example, the sense margin for sense 1 increases from m11 to m12 over time.

Still referring to FIG. 6, for cases where the second data line YIO needs to be read as 0, that is, for sense 0, the second data line YIO needs to change from 1 to 0. Because the reference module 102 has discharge performance, the voltage potential of the reference signal ref gradually decreases. The local read-write conversion module 101 also has discharge performance, and therefore, the voltage potential of the second data line YIO also gradually decreases. Because a discharge speed of the reference module 102 is less than a discharge speed of the local read-write conversion module 101, a rate of voltage potential change of the second data line YIO is greater than a rate of voltage potential change of the reference signal ref. In other words, compared with the reference data line YIO#, the voltage potential of the second data line YIO is lower. Therefore, the voltage potential of the second data line YIO changes to 0 first, and the second data line YIO is read as 0. In addition, a sense margin for sense 0 (sense margin for 0) increases over time. For example, the sense margin for sense 0 changes from m01 to m02 over time.

As such, it follows that during a data read operation, sense margins for sense 0 and sense 1 both increase over time, such that the difference between the sense margins for sense 0 and sense 1 can be reduced.

It should be noted that, during a data read operation, when the second data line YIO changes from 1 to 0, that is, in the discharging process of the local read-write conversion module 101, the local read-write conversion module 101 has the first discharge speed; when the reference data line YIO# changes from 1 to 0, that is, in the discharge process of the reference module 102, the reference module 102 has the second discharge speed.

In general, the sense margin for sense 0 has an ideal sense margin (ideal sense margin for 0), which is referred to as a first ideal sense margin m00. The first ideal sense margin m00 is an absolute value of a voltage potential difference between the reference data line YIO# and the second data line YIO when the discharge of the second data line YIO ends during reading the second data line YIO as 0. The sense margin for sense 1 has an ideal sense margin (ideal sense margin for 1), which is referred to as a second ideal sense margin m10. The second ideal sense margin m10 is an absolute value of a voltage potential difference between the reference data line YIO# and the second data line YIO after the reference module 102 has discharged for a proper time during reading the second data line YIO as 1.

In an ideal case, the first ideal sense margin m00 and the second ideal sense margin m10 can be the same. It may be understood that a circuit of the reference module 102 may be modified to adjust the second discharge speed of the reference module 102. Likewise, a circuit of the local read-write conversion module 101 may be modified to adjust the first discharge speed of the local read-write conversion module 101. In this way, the first ideal sense margin m00 can be made equal to the second ideal sense margin m10.

In some embodiments, the first ideal sense margin m00 may be less than the second ideal sense margin m10. In some cases, the first ideal sense margin m00 may be greater than the second ideal sense margin m10.

The amplifier module 103 can be a differential amplifier having two input ends. The two input ends are respectively connected to the second data line YIO and the reference data line YIO#. The data of the second data line YIO is amplified and output.

For example, during a data read operation, when the second data line YIO changes from 1 to 0, data signals of the second data line YIO and the reference data line YIO# are both pulled down. However, because a pull-down speed of the data signal of the second data line YIO is greater than a pull-down speed of the reference signal of the reference data line YIO#, the differential amplifier outputs 0.

It may be understood that, for a data read operation, if "1" is being read, the second data line YIO is at a binary value of 1, and the voltage potential of the second data line YIO is higher than the voltage potential of the reference data line YIO#. If "0" is being read, the voltage potential of the second data line YIO is lower than the voltage potential of the reference data line YIO# during the second data line YIO changes from 1 to 0.

In an embodiment, the reference module 102 can include at least one transistor.

In the embodiment, the semiconductor integrated circuit can further include a reference control line Co configured to provide a reference control signal cnt. The reference module 102 can be connected to the reference control line Co. The reference module 102 can be configured to output the reference signal ref to the reference data line YIO# in response to the read control signal Rd and the reference control signal cnt.

The read control signal Rd and the reference control signal cnt can jointly affect the reference module 102, such that the discharge speed of the reference module 102 can be controlled better. In this way, a relationship between the first discharge speed and the second discharge speed can be controlled better, and the problem of sense margin inconsistency can be further alleviated.

In some embodiments, the reference module may respond only to the read control signal. In other embodiments, the reference module may respond to another control signal in addition to the read control signal and the reference control signal.

In the embodiment, the semiconductor integrated circuit may further include a virtual module 104. The virtual module 104 can receive the write control signal Wr. The virtual module 104 can be connected to the reference data line YIO# to make the reference data line YIO# consistent with the second data line YIO. For cases in which the reference data line YIO# is consistent with the second data line YIO, a circuit structure around the reference data line YIO# is consistent with a circuit structure around the second data line YIO, and a noise and other effects on the reference data line YIO# are consistent with that on the second data line YIO.

The virtual module 104 can have same quantity of transistors as the reference module 102.

In the semiconductor integrated circuit, the virtual module 104 is not required to participate in data transmission. The virtual module 104 can be configured to alleviate or offset noise problems caused by the reference module 102, and is conducive to symmetry of layout.

In the embodiment, the semiconductor integrated circuit may further include a local amplifier module 105. The local amplifier module 105 can be connected between the first data line Ldat and the first complementary data line Ldat#, and is configured to amplify data of the first data line Ldat and data of the first complementary data line Ldat#.

In the embodiment, during a data read operation, the reference module 102 can discharge when the reference control signal cnt provided by the reference control line Co is at a high level. In other embodiments, during the data read operation, the reference module 102 may discharge when the reference control signal cnt provided by the reference control line Co is at a low level.

According to the semiconductor integrated circuit provided in this embodiment, the reference signal that changes with the data signal of the second data line YIO can be provided while a number of second data lines YIO is reduced. This helps to ensure the consistency between the sense margin for sense 0 and the sense margin for sense 1. More specifically, both the sense margin for sense 0 and the sense margin for sense 1 increase over time. Therefore, the difference between the sense margin for sense 0 and the sense margin for sense 1 is small, so that the accuracy of amplifying the second data line YIO by the amplifier module 103 is further improved.

In addition, during a data read operation, when the second data line YIO changes from 1 to 0, the local read-write conversion module 101 has the first discharge speed. During the data read operation, the reference module 102 has the second discharge speed, and the second discharge speed is less than the first discharge speed. This configuration ensures that during the second data line YIO changes from 1 to 0, the voltage potential of the second data line YIO is always lower than the voltage potential of the reference signal ref. During this time period, regardless of when the amplifier module 103 amplifies the second data line YIO, it can be ensured that the second data line YIO amplified by the amplifier module 103 is 0, so that the accuracy of reading the second data line YIO as 0 is further improved.

A third embodiment of the present invention further provides a semiconductor integrated circuit. The semiconductor integrated circuit provided in this embodiment is roughly the same as the semiconductor integrated circuit in the foregoing embodiments. Differences lie in that the reference module is further explained in this embodiment. The semiconductor integrated circuit provided in this embodiment is described below with reference to the accompanying drawings. For parts that are the same as or corresponding to those in the foregoing embodiments, reference is made to the detailed descriptions in the foregoing embodiments. Details are omitted below for simplicity.

FIG. 7 is a schematic diagram of a semiconductor integrated circuit according to a third embodiment of the present invention.

In the embodiment, the semiconductor integrated circuit includes a first data line Ldat connected to a bit line BL through a column selection module 200, a first complementary data line Ldat# connected to a complementary bit line BL# through the column selection module 200, a second data line YIO, a reference control line Co, a reference data line YIO#, a local read-write conversion module 201, a reference module 202, and an amplifier module 203. The reference module 202 can be configured to output a reference signal ref to the reference data line YIO# in response to a read control signal Rd and a reference control signal cnt provided by the reference control line Co. The reference signal ref can serve as a reference for a data signal of the second data line YIO. During a data read operation, the reference module 202 can have a discharge characteristic, to enable a voltage potential of the reference signal ref to gradually decrease.

It should be noted that, the semiconductor integrated circuit including the reference control line Co will be described below as an example. In other embodiments, the semiconductor integrated circuit may not include the reference control line Co. In other words, the reference module does not need to respond to the reference control signal. In the embodiment, the reference module 202 can have a first port A, a second port B, a third port C, and a fourth port D. The first port A can receive the read control signal Rd, the second port B can be connected to the reference data line YIO#, the third port C can be grounded, and the fourth port D can receive the reference control signal cnt. The reference module 202 can discharge between the second port B and the third port C in response to the read control signal Rd and the reference control signal cnt, to gradually reduce a voltage potential of the reference data line YIO#.

Specifically, there may be the following situations regarding the working mechanism of the reference module 202. During a data read operation, the read control signal Rd is at a high level and the reference control signal cnt is also at a high level. In this example, the reference module 202 is turned on and performs discharging between the second port B and the third port C. In other words, the voltage potential of the reference data line YIO# is pulled down to 0. In another example, during a data read operation, when the read control signal Rd is at a high level and the reference control signal cnt is at a low level, the reference module 202 is turned on and performs discharging between the second port B and the third port C, in other words, the voltage potential of the reference data line YIO# is pulled down to 0.

It may be understood that the working principle is described based on a condition for performing a data read operation when the read control signal Rd is at a high voltage. Similarly, when the condition for performing the read operation is that the read control signal is at a low voltage, "the read control signal Rd is at a high level" in the foregoing working principle may be replaced with "the read control signal Rd is at a low level".

The reference module 202 can include a first switch unit 211 and a second switch unit 212. The first switch unit 211 can be connected to the first port A and the third port C. The first switch unit 211 can have a first node a, and the first switch unit 211 can be turned on in response to the read control signal Rd, to connect the first node a to the third port C. The second switch unit 212 can be connected to the second port B and the fourth port D. The second switch unit 212 can have a second node b that is connected to the first node a. The second switch unit 212 can be turned on in response to the reference control signal cnt, to connect the second port B to the second node b.

In this way, the second port B can be grounded through the first switch unit 211 and the second switch unit 212. Therefore, a data signal of the reference data line YIO# can be pulled down to 0.

In another embodiment, the reference module may also be configured such that the first switch unit is connected to the fourth port and the third port, and the first switch unit is turned on in response to the reference control signal; the second switch unit is connected to the first port and the second port, and the second switch unit is turned on in response to the read control signal.

The first switch unit 211 can include at least one transistor. The second switch unit 212 can include at least one transistor. The transistors associated with the first switch unit 211 or the second switch unit 212 may be a PMOS transistor or an NMOS transistor.

It should be noted that, in another embodiment, when the reference module is responsive only to the read control signal, the reference module 202 includes only the first switch unit.

In the embodiment, during a data read operation, the local read-write conversion module 201 has a first discharge speed such that data of the second data line YIO is reduced from a first level to a second level (i.e., the second data line YIO changes from 1 to 0). During the data read operation, the reference module 202 has a second discharge speed that is less than the first discharge speed, so that the voltage potential of the reference signal ref is higher than the voltage potential of the data signal of the second data line YIO during the data signal of the second data line YIO is reduced from the first level to the second level.

In the embodiment, the local read-write conversion module 201 includes a local read unit 221. The discharge speed of the local read-write conversion module 201 corresponds to a discharge speed of the local read unit 221. The local read unit 221 may also include multiple transistors. Specifically, the local read unit 221 can transmit a data signal of the first data line Ldat or the first complementary data line Ldat# to the second data line YIO during a data read operation in response to the read control signal. In an implementation, the local read unit 221 includes at least two local transistors, the reference module 202 includes at least one reference transistor, and a conductivity of the at least one reference transistor is weaker than conductivities of the local transistors. In this way, a discharge speed of the reference module 202 is less than the discharge speed of the local read unit 221. In general, the stronger a conductivity of a transistor, the higher a corresponding discharge speed, and the weaker a conductivity of a transistor, the lower the corresponding discharge speed.

The transistors of the local read unit 221 can be PMOS transistors or NMOS transistors. It may be understood that a transistor type of the local read unit 221 is the same as a transistor type of the reference module 202. For example, both of the transistors can be PMOS transistors, or NMOS transistors.

The discharge speed of the local read unit 221 can be related to a number of transistors in the local read unit 221 and characteristics of the transistors. Similarly, the discharge speed of the reference module 202 can be related to a number of transistors in the reference module 202 and characteristics of the transistors. The characteristics of the transistors can include channel widths of the transistors. The number of transistors in the reference module 202 may be the same as the number of transistors in the local read unit 221, and a channel width of the transistor in the reference module 202 is less than a channel width of the transistor in the local read unit 221. In this way, it can be ensured that the discharge speed of the reference module 202 is less than the discharge speed of the local read-write conversion module 201. A person skilled in the art should understand that different discharge speeds may also be set by designing different performance parameters such as threshold voltages.

For example, the channel width of the transistor in the reference module 202 can be less than or equal to 2/3 of the channel width of the transistor in the local read unit 221. For example, the channel width of the transistor of the reference module 202 may be 1/2 of the channel width of the transistor in the local read unit 221.

Compared with the reference module 202 responding only to the read control signal Rd, the solution that the reference module 202 responds to both the read control signal Rd and the reference control signal cnt helps to make quantities of transistors of the reference module 202 and the local read unit 221 consistent. In this way, a difference between the discharge speed of the local read-write conversion module and the discharge speed of the reference module can be controlled more effectively. As such, data of the second data line YIO can be read as 1 or 0 more quickly.

The semiconductor integrated circuit may further include a virtual module 204 and a local amplifier module 205. For detailed descriptions of the virtual module 204 and the local amplifier module 205, reference is made to the foregoing embodiments. Details are omitted herein for simplicity.

The semiconductor integrated circuit will be described in detail below in conjunction with the working mechanism of the semiconductor integrated circuit.

Before a data read operation is performed, the reference data line YIO# may be precharged to be at a high level. That is, the reference signal ref is a high level signal.

During the data read operation, when the second data line YIO changes from 0 to 1 or remains at 1, the reference module 202 becomes conductive and a conductive path is formed between the second port B and the third port C to discharge, thereby pulling-down the voltage potential of the reference data line YIO# to 0, i.e., the reference signal ref is pulled down to 0. In the voltage potential pull-down process, voltage potential differences between the reference data line YIO# and the second data line YIO gradually increases, and therefore, the sense margin for sense 1 of the amplifier module 203 gradually increases. In addition, as the voltage potential differences between the reference data line YIO# and the second data line YIO becomes larger, it is less difficult to read the data of the second data line YIO as 1 based on the reference signal ref.

During a data read operation, when the second data line YIO changes from 0 to 1, the reference module 202 becomes conductive and a conductive path is formed between the second port B and the third port C to discharge, thereby pulling-down the voltage potential of the reference data line YIO# to 0, i.e., the reference signal ref is pulled down from 1 to 0. In addition, the local read-write conversion module 201 is also in the discharge period, that is, the voltage potential of the second data line YIO is pulled down from 1 to 0. The first discharge speed of the local read-write conversion module 201 is greater than the second discharge speed of the reference module 202. Therefore, comparing with the reference data line YIO#, the voltage potential of the second data line YIO is pulled down to 0 quicker, and a voltage potential difference between the reference data line YIO# and the second data line YIO becomes larger. Because of the reference signal ref, it is less difficult to read the second data line YIO as 0. In addition, in the voltage potential pull-down process, the voltage potential difference between the reference data line YIO# and the second data line YIO gradually increases, and therefore, the sense margin for sense 0 gradually increases.

As such, during a data read operation, the sense margins for sense 0 and sense 1 both can increase over time. This avoids the problem that the difference between the sense margins for sense 0 and sense 1 becomes too large over time.

In general, the second data line YIO remaining at 1 means that the second data line YIO has been precharged to a high level before performing a data read operation. Therefore, the second data line YIO is at 1 before the data read operation. When data of the first data line Ldat is transmitted to the second data line YIO and the first data line Ldat is at 1, the second data line YIO remains at 1 during the data read operation.

A fourth embodiment of the present invention further provides a semiconductor integrated circuit. The semiconductor integrated circuit provided in this embodiment is roughly the same as the semiconductor integrated circuit in the foregoing embodiments. Differences lie in that specifics of the local read conversion module and the reference module are further described in detail in this embodiment. The following describes the semiconductor integrated circuit provided in this embodiment with reference to the accompanying drawings. For the parts the same as or corresponding to those in the foregoing embodiments, reference is made to the detailed descriptions in the foregoing embodiments. Details are omitted below for simplicity.

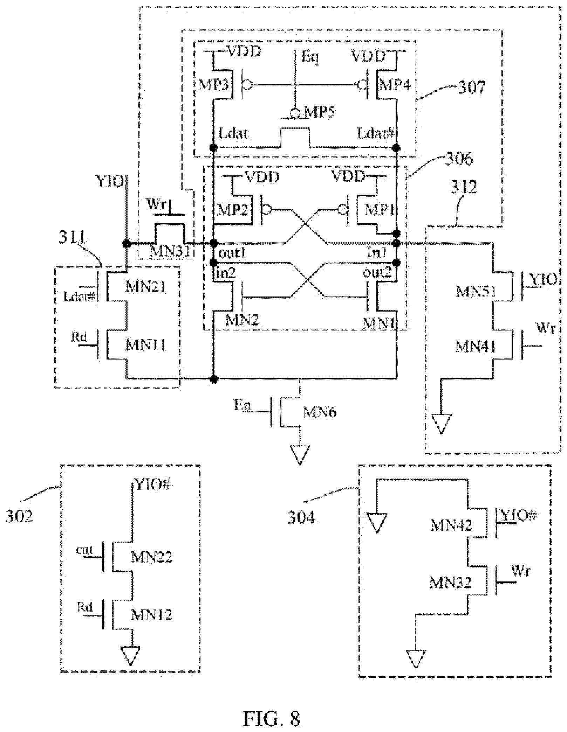

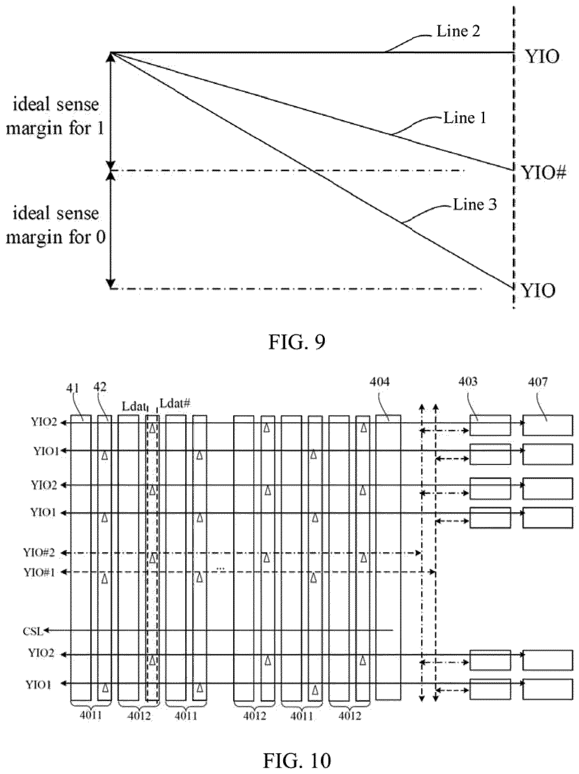

FIG. 8 is an electrical schematic of a semiconductor integrated circuit according to a fourth embodiment of the present invention. Part of the circuit shown in FIG. 8 is the same as the circuit shown in FIG. 2. FIG. 9 is a schematic diagram illustrating voltage potential changes of a second data line and a reference data line during a data read operation.

Referring to FIG. 8, in the embodiment, the semiconductor integrated circuit can include a first data line Ldat, a first complementary data line Ldat#, a second data line YIO, a reference control line Co, and a reference data line YIO#. The semiconductor integrated circuit can further include a local read-write conversion module (not shown in FIG. 8), a reference module 302, and an amplifier module (not shown in FIG. 8). During a data read operation, when a voltage potential of the second data line YIO is reduced from a first level to a second level, the local read-write conversion module has a first discharge speed. The reference module 302 can be configured to output a reference signal ref to the reference data line YIO# in response to a read control signal Rd and a reference control signal cnt provided by the reference control line Co. The reference signal ref serves as a reference for a data signal of the second data line YIO. During the data read operation, the reference module 302 has a discharge characteristic, and the reference module 302 has a second discharge speed that is less than the first discharge speed.

The following describes in detail the semiconductor integrated circuit provided in this embodiment with reference to the accompanying drawings. It should be noted that for the parts in FIG. 8 that are the same as those in FIG. 2, reference is made to the detailed descriptions in the foregoing embodiments. Details are omitted below for simplicity. In this embodiment, the local read-write conversion module includes a local read unit 311, configured to transmit a data signal of the first data line Ldat or the first complementary data line Ldat# to the second data line YIO during a data read operation in response to the read control signal Rd.

During a data read operation, both the reference module 302 and the local read unit 311 can have discharge characteristics. The discharge speed of the reference module 302 can be less than the discharge speed of the local read unit 311. To simplify the circuit and reduce the layout design difficulty, a circuit structure of the reference module 302 is similar to that of the local read unit 311, and it is necessary to ensure that the discharge speed of the circuit structure of the reference module 302 is less than the discharge speed of the circuit structure of the local read unit 311.

For example, the local read unit 311 can include at least two local transistors and the reference module 302 can include at least one reference transistor. A channel width of the at least one reference transistor is less than a channel width of the local transistor.

A type of the local transistor can be the same as that of the reference transistor. In the embodiment, both the local transistor and the reference transistor can be N-type transistors, that is, all the local transistors and the reference transistor are NMOS transistors.

In the embodiment, the channel width of each of the reference transistors is less than the channel width of each of the local transistors. For example, the channel width of the reference transistor is 1/2 of the channel width of the corresponding local transistor. It should be noted that, in another embodiment, the channel width of the reference transistor may be greater than or equal to the channel width of the local transistor, as long as the discharge speed of the reference module and the discharge speed of the local read unit meet the requirements.

In the embodiment, a number of local transistors is the same as a number of reference transistors.

Specifically, in the embodiment, the at least two local transistors include a local read control transistor MN11 and a local read transmission transistor MN21. The local read control transistor MN11 is configured to turn ON in response to a read control signal Rd, and a port of the local read control transistor MN11 is grounded. The local read transmission transistor MN21 is configured to turn ON in response to a data signal of the first complementary data line Ldat#, such that the second data line YIO is grounded via the local read transmission transistor MN21 and the local read control transistor MN11.

More specifically, a source of the local read control transistor MN11 is grounded, a drain of the local read control transistor MN11 is connected to a source of the local read transmission transistor MN21. A drain of the local read transmission transistor MN21 is connected to the second data line YIO. The source of the local read control transistor MN11 is directly grounded or grounded through a switch transistor.

The at least one reference transistor can include a reference control transistor MN12 configured to be turned on in response to the read control signal Rd to cause the reference data line YIO# to be grounded through the reference control transistor MN12. A channel width of the reference control transistor MN12 can be less than a channel width of the local read control transistor MN11.

In the embodiment, the at least one reference transistor can further include a reference transmission transistor MN22 configured to be turned on in response to the reference control signal cnt to cause the reference data line YIO# to be grounded through the reference control transistor MN12 and the reference transmission transistor MN22. The reference transmission transistor MN22 can have a channel width that is less than a channel width of the local read transmission transistor MN21.

More specifically, a source of the reference control transistor MN12 can be grounded and a drain of the reference control transistor MN12 can be connected to a source of the reference transmission transistor MN22. A gate of the reference transmission transistor MN22 can be connected to the reference control line Co, and a drain of the reference transmission transistor MN22 can be connected to the reference data line YIO#.

Both the reference control transistor MN12 and the local read control transistor MN12 can be NMOS transistors. The channel width of the reference control transistor MN12 can be less than or equal to 2/3 of the channel width of the local read control transistor MN12. The channel width of the reference transmission transistor MN22 can be less than or equal to 2/3 of the channel width of the local transmission transistor MN21.

In the embodiments, the channel width of the reference control transistor MN12 can be 1/2 of the channel width of the local read control transistor MN11 and the channel width of the reference transmission transistor MN22 can be 1/2 of the channel width of the local read transmission transistor MN21. In this way, the second discharge speed of the reference module 302 can be 1/2 of the first discharge speed of the local read conversion module 301.

In another embodiment, a relationship between the second discharge speed and the first discharge speed can be properly adjusted based on actual needs. In other words, a proportion relationship between the channel width of the reference control transistor and the channel width of the local read control transistor may be properly adjusted, and a proportion relationship between the channel width of the reference transmission transistor and the channel width of the local read transmission transistor may be properly adjusted. For example, the channel width of the reference control transistor may be 1/3 or 1/4 of the channel width of the local read control transistor, and the channel width of the reference transmission transistor may be 1/3 or 1/4 of the channel width of the local read transmission transistor.

In the embodiment, positions of the reference control transistor MN12 and the reference transmission transistor MN22 in the semiconductor integrated circuit may be interchangeable. For example, the gate of the reference control transistor MN12 may receive the reference control signal cnt and the reference control transistor MN12 may be turned on in response to the reference control signal cnt, and the gate of the reference transmission transistor MN22 may receive the read control signal Rd and the reference transmission transistor MN22 may be turned on in response to the read control signal Rd.

In other embodiments, the reference module 302 may include only one reference transistor. A gate of the reference transistor receives the read control signal, and the channel width of the reference transistor is properly set to ensure that the second discharge speed of the reference module and the first discharge speed of the local read-write conversion module meet memory performance requirements.

In the embodiment, the semiconductor integrated circuit can further include a virtual module 304. The virtual module 304 can receive a write control signal Wr, and can be connected to the reference data line YIO#. A number of transistors of the virtual module 304 can be the same as a number of transistors of the reference module 302.

The virtual module 304 can include a virtual control transistor MN32 and a virtual transmission transistor MN42. A gate of the virtual control transistor MN32 can receive the write control signal Wr, and one port of the virtual control transistor MN32 can be grounded. A gate of the virtual transmission transistor MN42 can be connected to the reference data line YIO# and the other port of the virtual control transistor MN32 can be connected to one port of the virtual transmission transistor MN42. The other port of the virtual transmission transistor MN42 can be grounded.

Both the virtual control transistor MN32 and the virtual transmission transistor MN42 can be NMOS transistors. In general, a circuit structure of the virtual module 304 can be similar to a circuit structure of the local write transmission transistor MN51 and the second local write control transistor MN41 in the local write unit 312. The virtual transmission transistor and the virtual control transistor can be connected between two ground terminals. Therefore, the virtual module 304 actually does not participate in data transmission. By setting the virtual module 304, a situation of the reference data line YIO# may be basically consistent with a situation of the second data line YIO, and a noise problem can be alleviated or offset. As a result, the accuracy of amplification result of the amplifier module can be improved, the layout can be symmetric, and the layout difficulty can be reduced.

In the embodiment, the local read-write conversion module further includes a local write unit 312. The local write unit 312 can be configured to transmit a data signal of the second data line YIO to the first data line Ldat or the first complementary data line Ldat# during a data write operation in response to the write control signal Wr. For detailed descriptions of the local write unit 312, reference is made to the corresponding descriptions in the foregoing embodiments.

In the embodiment, the semiconductor integrated circuit can further include a local amplifier module 306. The local amplifier module 306 can be connected between the first data line Ldat and the first complementary data line Ldat#. The local amplifier module 306 can be configured to amplify data of the first data line Ldat and data of the first complementary data line Ldat#.

In the embodiment, the semiconductor integrated circuit can further include an enable NMOS transistor MN6. A gate of the enable NMOS transistor MN6 can receive an enable signal En and a source of the enable NMOS transistor MN6 can be grounded. The first phase inverter and the second phase inverter can be further connected to a drain of the enable NMOS transistor MN6. A source of the first NMOS transistor MN1 and a source of the second NMOS transistor MN2 can be connected to the drain of the enable NMOS transistor MN6.

In the embodiment, the semiconductor integrated circuit can further include a precharging module 307. The precharging module 307 can be connected between the first data line Ldat and the first complementary data line Ldat#. The precharging module 307 can be configured to precharge the first data line Ldat and the first complementary data line Ldat# in response to a precharging control signal Eq.

For detailed descriptions of the local amplifier module 306, the enable NMOS transistor MN6, and the precharging module 307, reference is made to the corresponding descriptions in the foregoing embodiments. Details are omitted herein for simplicity.

The semiconductor integrated circuit will be described below in conjunction with the working mechanism of the semiconductor integrated circuit provided in the embodiment.

Before a data read operation is performed, the second data line YIO and the reference data line YIO# are precharged to a high level. When the read control signal Rd is at a high level, the data read operation is performed. The first data line Ldat is at a high level, and the first complementary data line Ldat# is at a low level. As a result, the local read control transistor MN11 is turned ON and the local read transmission transistor MN21 is turned ON. As such, a path from the second data line YIO# to the ground is cut off, and the second data line YIO# remains at a high level. When the reference control signal cnt provided by the reference control line Co is at a high level, the reference control transistor MN12 is turned ON, and the reference transmission transistor MN22 is also turned ON. Therefore, a path from the reference data line YIO# to the ground becomes conductive. The reference data line YIO# then discharges to the ground through the reference control transistor MN12 and the reference transmission transistor MN22. Therefore, the voltage potential of the reference data line YIO# becomes lower and gradually changes to 0, and a voltage potential difference between the reference data line YIO# and the second data line YIO becomes larger. The voltage potential of the reference data line YIO# can serve as a reference, so that the amplifier module can amplify the second data line YIO to 1 in an accurate and timely manner. In addition, during discharging, a sense margin for sense 1 of the second data line YIO becomes larger, instead of being fixed.

Similarly, when the read control signal Rd is at a high level, the data read operation is performed. The first data line Ldat is at a low level, and the first complementary data line Ldat# is at a high level. Both the local read control transistor MN11 and the local read transmission transistor MN21 are turned ON, and the path from the second data line YIO to the ground becomes conductive. Therefore, the second data line YIO discharges to the ground through the local read control transistor MN11 and the local read transmission transistor MN21, and the voltage potential of the second data line YIO becomes lower and lower until it changes to 0. When the reference control signal cnt provided by the reference control line Co is at a high level, the reference control transistor MN12 and the reference transmission transistor MN22 are turned ON. Therefore, the path from the reference data line YIO# to the ground becomes conductive, and the reference data line YIO# discharges to the ground through the reference control transistor MN12 and the reference transmission transistor MN22, so that the voltage potential of the reference data line YIO# becomes lower and lower and gradually changes to 0. Because the discharge speed of the reference data line YIO# to the ground is less than the discharge speed of the second data line YIO to the ground, the second data line YIO is always closer to 0 than the reference data line YIO#, that is, the voltage potential of the second data line YIO is always lower than the voltage potential of the reference data line YIO#. As such, the voltage potential of the reference data line YIO# can serve as a reference, so that the amplifier module can effectively and accurately amplify the second data line YIO to 0 in a timely manner. In addition, during discharging, a sense margin for sense 0 of the second data line YIO becomes larger. Therefore, both the sense margins for sense 0 and sense 1 of the second data line YIO become larger, to avoid a case that a sense margin for sense 0 becomes larger while a sense margin for sense 1 remains unchanged.

As shown in FIG. 9, a line 1 is a voltage potential change of the reference data line YIO# over time, a line 2 is a voltage potential change of the second data line YIO over time during reading 1, and a line 3 is a voltage potential change of the second data line YIO over time during reading 0. A slope of the line 1 corresponds to the second discharge speed, and a slope of the line 3 corresponds to the first discharge speed. As shown in FIG. 9, the sense margin for reading 0 (namely, sense 0) by the semiconductor integrated circuit and the sense margin for reading 1 (namely, sense 1) by the semiconductor integrated circuit both can increase over time. A maximum sense margin for sense 0 is a first ideal sense margin (ideal sense margin for 0) and a maximum sense margin for sense 1 is a second ideal sense margin (ideal sense margin for 1). The first discharge speed and the second discharge speed can be adjusted to ensure that the first ideal sense margin is equal to the second ideal sense margin, thereby further improving memory read performance.

It should be noted that the foregoing embodiment is described in detail by using an example in which the semiconductor integrated circuit includes the reference control line Co. In some embodiments, the semiconductor integrated circuit may not include the reference control line Co. In such embodiments, the reference module does not need to respond to the reference control signal, and a corresponding reference transistor may not include the reference transmission transistor.

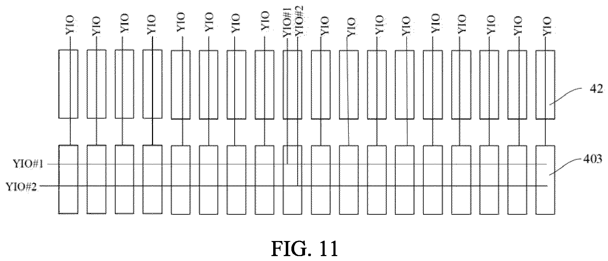

An embodiment of the invention also provides a memory, including the semiconductor integrated circuit in any of the foregoing embodiments. FIG. 10 is a schematic structural diagram of a memory according to an embodiment of the present invention, and FIG. 11 is a partial schematic diagram corresponding to FIG. 10 rotated 90° clockwise.

Referring to FIG. 10 and FIG. 11, the memory can include a plurality of memory cell arrays 41 and a plurality of sense amplifier arrays 42 that are alternately arranged. Each of the plurality of memory cell arrays 41 can be connected to at least one of the plurality of sense amplifier arrays 42 to form a memory array. According to the semiconductor integrated circuit discussed in the foregoing embodiments, each first data line Ldat and each first complementary data line Ldat# can be connected to a memory cell array 41 through a corresponding sense amplifier array 42 to perform a data read operation or a data write operation on the memory cell array 41 by using a local read-write conversion module. The semiconductor integrated circuit can include an amplifier module 403, a column decoding circuit 404, and a decoding selection signal line CSL. The decoding selection signal line CSL can be electrically connected to the column decoding circuit 404 and a memory array, so that the column decoding circuit 404 can position the memory array.

The memory will be described in detail below in conjunction with the drawings. In FIG. 10, a triangle can represent an electrical connection. Dashed lines on a single sense amplifier array 42 can indicate a first data line Ldat and a first complementary data line Ldat# connected to the sense amplifier array 42. First data lines and first complementary data lines connected to the other sense amplifier arrays are not shown.

Each memory array can include a memory cell array 41 and a sense amplifier array 42. The memory cell array 41 can include a plurality of storage elements configured to store data. The sense amplifier array 42 can be configured to amplify an output signal of the memory cell array. Because data of the second data line is transmitted in a single-phase manner, a quantity of data lines required in the memory can be reduced. In general, the quantity of the second data lines can be reduced from 2N in the related art to just N.

The sense amplifier array can include a plurality of first sense amplifier arrays 4011 in odd columns and a plurality of second sense amplifier arrays 4012 in even columns. For ease of illustration, in FIG. 10, the first sense amplifier array 4011 includes a memory cell array 41 connected to a sense amplifier array 42 in an odd column, and a second sense amplifier array 4012 includes a memory cell array 41 connected to a sense amplifier array 42 in an even column.

The second data lines YIO can include a first group of data lines YIO 1 corresponding to the plurality of first sense amplifier arrays 4011 and a second group of data lines YIO2 corresponding to the plurality of second sense amplifier arrays 4012. The first group of data lines YIO1 can correspond to first data lines Ldat and first complementary data lines Ldat# that are connected to the plurality of first sense amplifier arrays 4011. Similarly, the second group of data lines YIO2 can correspond to first data lines Ldat and first complementary data lines Ldat# that are connected to the plurality of second sense amplifier arrays 4012.

The reference data line can include a first reference data line YIO#1 configured to provide a first reference signal, and a second reference data line YIO#2 configured to provide a second reference signal. For ease of illustration, in FIG. 10, a dotted line is used to indicate the first reference data line YIO#1 and a dashed line is used to indicate the second reference data line YIO#2. The reference module can include a first reference unit and a second reference unit. The first reference unit can be adapted to output a first reference signal to the first reference data line YIO#1, and the first reference signal is used as a reference for data signals of the first group of data lines YIO1. The second reference unit can be adapted to output a second reference signal to the second reference data line YIO#2, and the second reference signal is used as a reference for data signals of the second group of data lines YIO2.

The amplifier module 403 can include a first group of amplifier modules and a second group of amplifier modules. The first group of amplifier modules can be configured to receive the first reference signal and the data signals of the first group of data lines YIO1, and amplify the data signals of the first group of data lines YIO1. The second group of amplifier modules can be configured to receive the second reference signal and data signals of the second group of data lines YIO2, and amplify the data signals of the second group of data lines YIO2.

The amplifier module 403 is connected to the second data line and the reference data line, and is configured to amplify and output the data signal of the second data line in response to the data signal of the second data line and the reference signal. The first group of amplifier modules can amplify the first group of data lines YIO1 connected to the plurality of first sense amplifier arrays 4011 in odd columns. Likewise, the second group of amplifier modules can amplify the second group of data lines YIO2 connected to the plurality of second sense amplifier arrays 4012 in even columns.

For a detailed description of the amplifier module, reference is made to the corresponding description in the foregoing embodiments.

FIG. 11 is a partial schematic diagram of the memory in a 90° clockwise rotation from FIG. 10. As shown in FIG. 11, one half of a plurality of second data lines YIO is located on one side of the first reference data line YIO#1 and the second reference data line YIO#2, and the other half of the plurality of second data lines YIO is located on the other side of the first reference data line YIO#1 and the second reference data line YIO#2. As such, the first reference data line YIO#1 and the second reference data line YIO#2 are arranged in a middle of all the second data lines YIO. In this way, path lengths from positions of the selected sense amplifier arrays 42 to the amplifier modules 403 at the end of the second data lines YIO are basically consistent, thereby alleviating a problem of power loss due to parasitics caused by inconsistent path lengths and further improving performance of the memory.

The first group of amplifier modules can correspond to the sense amplifier arrays 42 in odd columns. The second group of amplifier modules can correspond to the sense amplifier arrays 42 in even columns. In such embodiments, the first group of amplifier modules corresponding to the sense amplifier arrays 42 in the odd columns share the same first reference data line YIO#1. Likewise, the second group of amplifier modules corresponding to the sense amplifier arrays 42 in the even columns share the same second reference data line YIO#2.

The memory can further include global write control circuits 407. The global write control circuits 407 can be connected to various second data lines. Specifically, a global write control circuit 407 can be connected to the first group of data lines YIO1, and a second global write control circuit can be connected to the second group of data lines YIO2.

The memory provided in the embodiment may be a DRAM such as a DDR3 DRAM, a DDR4 DRAM, or a DDR5 DRAM. In some embodiments, the memory may be a SRAM, an MRAM, an FeRAM, a PCRAM, a NAND memory, a NOR memory, or the like.

For the working mechanism during the data read operation, reference may be made to the detailed description in the foregoing embodiments, which will not be repeated herein.

A person of ordinary skill in the art may understand that the foregoing embodiments are specific implementations of the present invention. In actual applications, various changes may be made to the implementations in terms of forms and details without departing from the scope of the present invention. Any person skilled in the art may make changes and modifications without departing from the scope of the present invention. Therefore, the protection scope of the present invention shall be subject to the scope of the claims.

## Claims

1. A semiconductor integrated circuit, applied to a memory comprising a column selection module (200) and a plurality of memory cells, wherein each of a bit line (BL) and a complementary bit line (BL#) is connected to at least one of the plurality of memory cells, and the column selection module (200) is connected to the bit line (BL) and the complementary bit line (BL#) for performing a data read operation or a data write operation on the memory cell;
wherein the semiconductor integrated circuit comprises:
a first data line (Ldat) connected to the bit line (BL) through the column selection module (200), a first complementary data line (Ldat#) connected to the complementary bit line (BL#) through the column selection module (200), and a second data line (YIO);
wherein the semiconductor integrated circuit further comprises:
a local amplifier module (15, 205) connected between the first data line (Ldat) and the first complementary data line (Ldat#) and configured to amplify a data signal of the first data line and a data signal of the first complementary data line;
a local read-write conversion module (201) comprising a local read unit (311) and a local write unit (312), wherein
the local read unit (311) comprises a local read control transistor (MN11) and a local read transmission transistor (MN21), a source of the local read control transistor (MN11) is grounded, a drain of the local read control transistor (MN11) is connected to a source of the local read transmission transistor (MN21), a gate of the local read control transistor (MN11) is configured to receive a read control signal (Rd), a drain of the local read transmission transistor (MN21) is connected to the second data line (YIO), and a gate of the local read transmission transistor (MN21) is connected to the first complementary data line (Ldat#); and the local read unit (311) is configured to transmit, in response to the read control signal (Rd), a level of an inverted data signal of the first complementary data line (Ldat#) to the second data line (YIO) during the data read operation; and
the local write unit (312) comprises a local write control transistor (MN31), a second local write control transistor (MN41), and a local write transmission transistor (MN51), a first port of the local write control transistor (MN31) is connected to the second data line (YIO), and a second port of the local write control transistor (MN31) is connected to the first data line (Ldat); and the local write unit (312) is configured to transmit, in response to a write control signal (Wr), a data signal of the second data line (YIO) to the first data line (Ldat) during the data write operation through the local write control transistor (MN31), a gate of the second local write control transistor (MN41) being configured to receive the write control signal (Wr), a first port of the second local write control transistor (MN41) being grounded and a second port of the second local write control transistor (MN41) being connected to a first port of the local write transmission transistor (MN51), a gate of the local write transmission transistor (MN51) being connected to the second data line (YIO) , and a second port of the local write transmission transistor (MN51) being connected to the first complementary data line (Ldat#).

2. The semiconductor integrated circuit of claim 1, further comprising:
a reference data line (YIO#) configured to provide a reference signal (Ref); and
an amplifier module (203) configured to receive the data signal of the second data line (YIO) and the reference signal (Ref), amplify the data signal of the second data line (YIO), and output the amplified data signal of the second data line (YIO), wherein the reference signal (Ref) serves as a reference for amplifying the data signal of the second data line (YIO).

3. The semiconductor integrated circuit of claim 2, wherein the reference data line (YIO#) has a fixed voltage potential.

4. The semiconductor integrated circuit of claim 2, further comprising:
a reference module (202, 302) configured to output the reference signal (Ref) to the reference data line (YIO#) in response to the read control signal (Rd), wherein the reference module (202, 302) has a discharge capability that causes a voltage potential of the reference signal (Ref) to gradually decrease during the data read operation.

5. The semiconductor integrated circuit of claim 4, wherein during the data read operation, when the second data line (YIO) is reduced from a first level to a second level, the local read-write conversion module (201) has a first discharge speed; and during the data read operation, the reference module (202, 302) has a second discharge speed, and the second discharge speed is less than the first discharge speed.

6. The semiconductor integrated circuit of claim 4, further comprising:
a reference control line (Co) configured to provide a reference control signal (cnt), wherein the reference module (202, 302) is connected to the reference control line (Co), and outputs the reference signal (Ref) to the reference data line (YIO#) in response to the reference control signal (cnt) and the read control signal (Rd).

7. The semiconductor integrated circuit of claim 6, wherein:
the reference module (202, 302) comprises a first port (A), a second port (B), a third port (C), and a fourth port (D);
the first port (A) is configured to receive the read control signal (Rd), the second port (B) is configured to connect to the reference data line (YIO#), the third port (C) is configured to be grounded, and the fourth port (D) is configured to receive the reference control signal (cnt); and
the reference module (202, 302) is configured to discharge, in response to the reference control signal (cnt) and the read control signal (Rd), from the second port (B) to the third port (C), to cause the voltage potential of the reference data line (YIO#) to gradually decrease.

8. The semiconductor integrated circuit of claim 7, wherein the reference module (202, 302) comprises a first switch unit (211) and a second switch unit (212), wherein:
the first switch unit (211) is connected between the first port (A) and the third port (C) and comprises a first node (a), and the first switch unit (211) is configured to be turned on in response to the read control signal (Rd) to form a conductive path between the first node (a) and the third port (C); and
the second switch unit (212) is connected between the second port (B) and the fourth port (D) and comprises a second node (b) connected to the first node (a), and the second switch unit (212) is configured to be turned on in response to the reference control signal (cnt) to form a conductive path between the second port (B) and the second node (b).

9. The semiconductor integrated circuit of claim 7, wherein the reference module (202, 302) comprises at least one reference transistor, and a conductivity of the at least one reference transistor is weaker than a conductivity of the local read control transistor (MN11) and a conductivity of the local read transmission transistor (MN21); and
wherein a channel width of the at least one reference transistor is less than channel widths of the local read control transistor (MN11) and the local read transmission transistor (MN21).

10. The semiconductor integrated circuit of claim 9, wherein the local read control transistor (MN11) is configured to be turned on in response to the read control signal (Rd); the local read transmission transistor (MN21) is configured to be turned on in response to the data signal of the first complementary data line (Ldat#), and the second data line (YIO) is grounded via the local read transmission transistor (MN21) and the local read control transistor (MN11); and
the at least one reference transistor comprises a reference control transistor (MN12) configured to be turned on in response to the read control signal (Rd), and the reference data line (YIO#) is grounded via the reference control transistor (MN12), wherein a channel width of the reference control transistor (MN12) is less than a channel width of the local read control transistor (MN11).

11. The semiconductor integrated circuit of claim 10, wherein the at least one reference transistor further comprises a reference transmission transistor (MN22) configured to be turned on in response to the reference control signal (cnt), and the reference data line (YIO#) is grounded via the reference control transistor (MN12) and the reference transmission transistor (MN22), wherein a channel width of the reference transmission transistor (MN22) is less than a channel width of the local read transmission transistor (MN21), preferably, the channel width of the reference control transistor (MN12) is less than or equal to 2/3 of the channel width of the local read control transistor (MN11), and the channel width of the reference transmission transistor (MN22) is less than or equal to 2/3 of the channel width of the local read transmission transistor (MN21), more preferably, the channel width of the reference control transistor (MN12) is 1/2 of the channel width of the local read control transistor (MN11), and the channel width of the reference transmission transistor (MN22) is 1/2 of the channel width of the local read transmission transistor (MN21).

12. The semiconductor integrated circuit of claim 4, wherein the amplifier module (203) comprises a differential amplifier, a first input end of the differential amplifier is connected to the second data line (YIO) and a second input end of the differential amplifier is connected to the reference data line (YIO#).

13. A memory, **characterized by** comprising:
a plurality of memory cell arrays (41) and a plurality of sense amplifier arrays (42) that are alternately arranged; wherein each of the plurality of memory cell arrays (41) is connected to at least one of the plurality of sense amplifier arrays (42) to form a memory array; and
a semiconductor integrated circuit of claim 1, wherein each of first data lines (Ldat) and each of first complementary data lines (Ldat#) of the semiconductor integrated circuit are connected to a respective memory cell array (41) through a corresponding sense amplifier array (42) to perform a data read operation or a data write operation on the memory cell array through a local read-write conversion module.

14. The memory of claim 13, wherein the plurality of sense amplifier arrays (42) comprise:
a plurality of first sense amplifier arrays (4011) disposed in odd columns; and
a plurality of second sense amplifier arrays (4012) disposed in even columns;
a plurality of second data lines (YIO) comprise a first group of data lines (YIO1) corresponding to the plurality of first sense amplifier arrays (4011) and a second group of data lines (YIO2) corresponding to the plurality of second sense amplifier arrays (4012), wherein the first group of data lines (YIO1) correspond to first data lines (Ldat) and first complementary data lines (Ldat#) that are connected to the plurality of first sense amplifier arrays (4011), and the second group of data lines (YIO2) correspond to first data lines (Ldat) and the first complementary data lines (Ldat#) that are connected to the plurality of second sense amplifier arrays (4012);
a reference data line (YIO#) comprises a first reference data line (YIO#1) configured to provide a first reference signal and a second reference data line (YIO#2) configured to provide a second reference signal; and
an amplifier module (403) comprises a first group of amplifier modules and a second group of amplifier modules, wherein the first group of amplifier modules are configured to receive the first reference signal and data signals of the first group of data lines (YIO1), and amplify the data signals of the first group of data lines (YIO1), and wherein the second group of amplifier modules are configured to receive the second reference signal and data signals of the second group of data lines (YIO2), and amplify the data signals of the second group of data lines (YIO2).

15. The memory of claim 14, wherein the first group of amplifier modules correspond to the sense amplifier arrays (4011) in the odd columns and the second group of amplifier modules correspond to the sense amplifier arrays (4012) in the even columns, and wherein the first group of amplifier modules share a same first reference data line (YIO#1) and the second group of amplifier modules share a same second reference data line (YIO#2);
or
wherein one half of the plurality of second data lines (YIO) are on one side of the first reference data line (YIO#1) and the second reference data line (YIO#2), and the other half of the plurality of second data lines (YIO) are on the other side of the first reference data line (YIO#1) and the second reference data line (YIO#2).

## Patentansprüche

1. Integrierte Halbleiterschaltung, die auf einen Speicher angewendet wird, umfassend ein Spaltenauswahlmodul (200) und eine Vielzahl von Speicherzellen, wobei jede von einer Bitleitung (BL) und einer komplementären Bitleitung (BL#) mit mindestens einer der Vielzahl von Speicherzellen verbunden ist, und das Spaltenauswahlmodul (200) mit der Bitleitung (BL) und der komplementären Bitleitung (BL#) verbunden ist, um einen Datenlesevorgang oder einen Datenschreibvorgang an der Speicherzelle durchzuführen;
wobei die integrierte Halbleiterschaltung Folgendes umfasst:
eine erste Datenleitung (Ldat), die über das Spaltenauswahlmodul (200) mit der Bitleitung (BL) verbunden ist, eine erste komplementäre Datenleitung (Ldat#), die über das Spaltenauswahlmodul (200) mit der komplementären Bitleitung (BL#) verbunden ist, und eine zweite Datenleitung (YIO);
wobei
die integrierte Halbleiterschaltung ferner Folgendes umfasst:
ein lokales Verstärkermodul (15, 205), das zwischen der ersten Datenleitung (Ldat) und der ersten komplementären Datenleitung (Ldat#) verbunden ist und konfiguriert ist, um ein Datensignal der ersten Datenleitung und ein Datensignal der ersten komplementären Datenleitung zu verstärken;
ein lokales Lese-Schreib-Umwandlungsmodul (201), umfassend eine lokale Leseeinheit (311) und eine lokale Schreibeinheit (312), wobei
die lokale Leseeinheit (311) einen lokalen Lesesteuertransistor (MN11) und einen lokalen Leseübertragungstransistor (MN21) umfasst, eine Source des lokalen Lesesteuertransistors (MN11) geerdet ist, ein Drain des lokalen Lesesteuertransistors (MN11) mit einer Source des lokalen Leseübertragungstransistors (MN21) verbunden ist, ein Gate des lokalen Lesesteuertransistors (MN11) konfiguriert ist, um ein Lesesteuersignal (Rd) zu empfangen, ein Drain des lokalen Leseübertragungstransistors (MN21) mit der zweiten Datenleitung (YIO) verbunden ist, und ein Gate des lokalen Leseübertragungstransistors (MN21) mit der ersten komplementären Datenleitung (Ldat#) verbunden ist; und die lokale Leseeinheit (311) konfiguriert ist, um als Reaktion auf das Lesesteuersignal (Rd) einen Pegel eines invertierten Datensignals der ersten komplementären Datenleitung (Ldat#) während des Datenlesevorgangs an die zweite Datenleitung (YIO) zu übertragen; und
die lokale Schreibeinheit (312) einen lokalen Schreibsteuertransistor (MN31), einen zweiten lokalen Schreibsteuertransistor (MN41) und einen lokalen Schreibübertragungstransistor (MN51) umfasst, ein erster Anschluss des lokalen Schreibsteuertransistors (MN31) mit der zweiten Datenleitung (YIO) verbunden ist und ein zweiter Anschluss des lokalen Schreibsteuertransistors (MN31) mit der ersten Datenleitung (Ldat) verbunden ist; und die lokale Schreibeinheit (312) konfiguriert ist, um als Reaktion auf ein Schreibsteuersignal (Wr) während des Datenschreibvorgangs ein Datensignal der zweiten Datenleitung (YIO) über den lokalen Schreibsteuertransistor (MN31) an die erste Datenleitung (Ldat) zu übertragen, wobei ein Gate des zweiten lokalen Schreibsteuertransistors (MN41) konfiguriert ist, um das Schreibsteuersignal (Wr) zu empfangen, ein erster Anschluss des zweiten lokalen Schreibsteuertransistors (MN41) geerdet ist und ein zweiter Anschluss des zweiten lokalen Schreibsteuertransistors (MN41) mit einem ersten Anschluss des lokalen Schreibübertragungstransistors (MN51) verbunden ist, wobei ein Gate des lokalen Schreibübertragungstransistors (MN51) mit der zweiten Datenleitung (YIO) verbunden ist, und ein zweiter Anschluss des lokalen Schreibübertragungstransistors (MN51) mit der ersten komplementären Datenleitung (Ldat#) verbunden ist.

2. Integrierte Halbleiterschaltung nach Anspruch 1, ferner umfassend:
eine Referenzdatenleitung (YIO#), die konfiguriert ist, um ein Referenzsignal (Ref) bereitzustellen; und
ein Verstärkermodul (203), das konfiguriert ist, um das Datensignal der zweiten Datenleitung (YIO) und das Referenzsignal (Ref) zu empfangen, das Datensignal der zweiten Datenleitung (YIO) zu verstärken und das verstärkte Datensignal der zweiten Datenleitung (YIO) auszugeben, wobei das Referenzsignal (Ref) als Referenz zum Verstärken des Datensignals der zweiten Datenleitung (YIO) dient.

3. Integrierte Halbleiterschaltung nach Anspruch 2, wobei die Referenzdatenleitung (YIO#) ein festes Spannungspotential aufweist.

4. Integrierte Halbleiterschaltung nach Anspruch 2, ferner umfassend:
ein Referenzmodul (202, 302), das konfiguriert ist, um das Referenzsignal (Ref) als Reaktion auf das Lesesteuersignal (Rd) an die Referenzdatenleitung (YIO#) auszugeben, wobei das Referenzmodul (202, 302) eine Entladefähigkeit aufweist, die bewirkt, dass ein Spannungspotenzial des Referenzsignals (Ref) während des Datenlesevorgangs allmählich abnimmt.

5. Integrierte Halbleiterschaltung nach Anspruch 4, wobei, wenn die zweite Datenleitung (YIO) während des Datenlesevorgangs von einem ersten Pegel auf einen zweiten Pegel reduziert wird, das lokale Lese-Schreib-Umwandlungsmodul (201) eine erste Entladungsgeschwindigkeit aufweist; und während des Datenlesevorgangs das Referenzmodul (202, 302) eine zweite Entladungsgeschwindigkeit aufweist, und die zweite Entladungsgeschwindigkeit niedriger ist als die erste Entladungsgeschwindigkeit.

6. Integrierte Halbleiterschaltung nach Anspruch 4, ferner umfassend:
eine Referenzsteuerleitung (Co), die konfiguriert ist, um ein Referenzsteuersignal (cnt) bereitzustellen, wobei das Referenzmodul (202, 302) mit der Referenzsteuerleitung (Co) verbunden ist und das Referenzsignal (Ref) als Reaktion auf das Referenzsteuersignal (cnt) und das Lesesteuersignal (Rd) an die Referenzdatenleitung (YIO#) ausgibt.

7. Integrierte Halbleiterschaltung nach Anspruch 6, wobei:
das Referenzmodul (202, 302) einen ersten Anschluss (A), einen zweiten Anschluss (B), einen dritten Anschluss (C) und einen vierten Anschluss (D) umfasst;
der erste Anschluss (A) konfiguriert ist, um das Lesesteuersignal (Rd) zu empfangen, der zweite Anschluss (B) konfiguriert ist, um mit der Referenzdatenleitung (YIO#) verbunden zu sein, der dritte Anschluss (C) konfiguriert ist, um geerdet zu sein, und der vierte Anschluss (D) konfiguriert ist, um das Referenzsteuersignal (cnt) zu empfangen; und
das Referenzmodul (202, 302) konfiguriert ist, um als Reaktion auf das Referenzsteuersignal (cnt) und das Lesesteuersignal (Rd) von dem zweiten Anschluss (B) zu dem dritten Anschluss (C) zu entladen, um zu bewirken, dass das Spannungspotenzial der Referenzdatenleitung (YIO#) allmählich abnimmt.

8. Integrierte Halbleiterschaltung nach Anspruch 7, wobei das Referenzmodul (202, 302) eine erste Schalteinheit (211) und eine zweite Schalteinheit (212) umfasst, wobei:
die erste Schalteinheit (211) zwischen dem ersten Anschluss (A) und dem dritten Anschluss (C) verbunden ist und einen ersten Knoten (a) umfasst, und die erste Schalteinheit (211) konfiguriert ist, um als Reaktion auf das Lesesteuersignal (Rd) eingeschaltet zu werden, um einen leitenden Pfad zwischen dem ersten Knoten (a) und dem dritten Anschluss (C) zu bilden; und
die zweite Schalteinheit (212) zwischen dem zweiten Anschluss (B) und dem vierten Anschluss (D) verbunden ist und einen zweiten Knoten (b) umfasst, der mit dem ersten Knoten (a) verbunden ist, und die zweite Schalteinheit (212) konfiguriert ist, um als Reaktion auf das Referenzsteuersignal (cnt) eingeschaltet zu werden, um einen leitenden Pfad zwischen dem zweiten Anschluss (B) und dem zweiten Knoten (b) zu bilden.

9. Integrierte Halbleiterschaltung nach Anspruch 7, wobei das Referenzmodul (202, 302) mindestens einen Referenztransistor umfasst und eine Leitfähigkeit des mindestens einen Referenztransistors schwächer ist als eine Leitfähigkeit des lokalen Lesesteuertransistors (MN11) und eine Leitfähigkeit des lokalen Leseübertragungstransistors (MN21); und
wobei eine Kanalbreite des mindestens einen Referenztransistors kleiner ist als die Kanalbreiten des lokalen Lesesteuertransistors (MN11) und des lokalen Leseübertragungstransistors (MN21).

10. Integrierte Halbleiterschaltung nach Anspruch 9, wobei der lokale Lesesteuertransistor (MN11) konfiguriert ist, um als Reaktion auf das Lesesteuersignal (Rd) eingeschaltet zu werden; der lokale Leseübertragungstransistor (MN21) konfiguriert ist, um als Reaktion auf das Datensignal der ersten komplementären Datenleitung (Ldat#) eingeschaltet zu werden, und die zweite Datenleitung (YIO) über den lokalen Leseübertragungstransistor (MN21) und den lokalen Lesesteuertransistor (MN11) geerdet ist; und
der mindestens eine Referenztransistor einen Referenzsteuertransistor (MN12) umfasst, der konfiguriert ist, um als Reaktion auf das Lesesteuersignal (Rd) eingeschaltet zu werden, und die Referenzdatenleitung (YIO#) über den Referenzsteuertransistor (MN12) geerdet ist, wobei eine Kanalbreite des Referenzsteuertransistors (MN12) kleiner ist als eine Kanalbreite des lokalen Lesesteuertransistors (MN 11).

11. Integrierte Halbleiterschaltung nach Anspruch 10, wobei der mindestens eine Referenztransistor ferner einen Referenztransmissionstransistor (MN22) umfasst, der konfiguriert ist, um als Reaktion auf das Referenzsteuersignal (cnt) eingeschaltet zu werden, und die Referenzdatenleitung (YIO#) über den Referenzsteuertransistor (MN12) und den Referenztransmissionstransistor (MN22) geerdet ist, wobei eine Kanalbreite des Referenztransistors (MN22) kleiner ist als eine Kanalbreite des lokalen Leseübertragungstransistors (MN21), vorzugsweise, die Kanalbreite des Referenz-Steuertransistors (MN12) kleiner als oder gleich wie 2/3 der Kanalbreite des lokalen Lesesteuertransistors (MN11) ist, und die Kanalbreite des Referenzübertragungstransistors (MN22) kleiner als oder gleich wie 2/3 der Kanalbreite des lokalen Leseübertragungstransistors (MN21) ist, weiter bevorzugt ist die Kanalbreite des Referenz-Steuertransistors (MN12) 1/2 der Kanalbreite des lokalen Lesesteuertransistors (MN11), und die Kanalbreite des Referenzübertragungstransistors (MN22) ist 1/2 der Kanalbreite des lokalen Leseübertragungstransistors (MN21).

12. Integrierte Halbleiterschaltung nach Anspruch 4, wobei das Verstärkermodul (203) einen Differenzverstärker umfasst, ein erstes Eingangsende des Differenzverstärkers mit der zweiten Datenleitung (YIO) verbunden ist und ein zweites Eingangsende des Differenzverstärkers mit der Referenzdatenleitung (YIO#) verbunden ist.

13. Speicher, **dadurch gekennzeichnet, dass** er Folgendes umfasst:
eine Vielzahl von Speicherzellenanordnungen (41) und eine Vielzahl von Leseverstärkeranordnungen (42), die abwechselnd angeordnet sind; wobei jede der Vielzahl von Speicherzellenanordnungen (41) mit mindestens einer der Vielzahl von Leseverstärkeranordnungen (42) verbunden ist, um eine Speicheranordnung zu bilden; und
eine integrierte Halbleiterschaltung nach Anspruch 1, wobei jede der ersten Datenleitungen (Ldat) und jede der ersten komplementären Datenleitungen (Ldat#) der integrierten Halbleiterschaltung über eine entsprechende Leseverstärkeranordnung (42) mit einer jeweiligen Speicherzellenanordnung (41) verbunden sind, um über ein lokales Lese-Schreib-Umwandlungsmodul einen Datenlesevorgang oder einen Datenschreibvorgang auf der Speicherzellenanordnung durchzuführen.

14. Speicher nach Anspruch 13, wobei die Vielzahl von Leseverstärkeranordnungen (42) Folgendes umfasst:
eine Vielzahl von ersten Leseverstärkeranordnungen (4011), die in ungeraden Spalten angeordnet sind; und
eine Vielzahl von zweiten Leseverstärkeranordnungen (4012), die in geraden Spalten angeordnet sind;
wobei eine Vielzahl von zweiten Datenleitungen (YIO) eine erste Gruppe von Datenleitungen (YIO1), die der Vielzahl von ersten Leseverstärkeranordnungs (4011) entsprechen, und eine zweite Gruppe von Datenleitungen (YIO2), die der Vielzahl von zweiten Leseverstärkeranordnungen (4012) entsprechen, umfasst, wobei die erste Gruppe von Datenleitungen (YIO1) ersten Datenleitungen (Ldat) und ersten komplementären Datenleitungen (Ldat#) entspricht, die mit der Vielzahl von ersten Leseverstärkeranordnungen (4011) verbunden sind, und die zweite Gruppe von Datenleitungen (YIO2) ersten Datenleitungen (Ldat) und den ersten komplementären Datenleitungen (Ldat#) entspricht, die mit der Vielzahl von zweiten Leseverstärkeranordnungen (4012) verbunden sind;
eine Referenzdatenleitung (YIO#) eine erste Referenzdatenleitung (YIO#1), die konfiguriert ist, um ein erstes Referenzsignal bereitzustellen, und eine zweite Referenzdatenleitung (YIO#2), die konfiguriert ist, um ein zweites Referenzsignal bereitzustellen, umfasst; und
ein Verstärkermodul (403) eine erste Gruppe von Verstärkermodulen und eine zweite Gruppe von Verstärkermodulen umfasst, wobei die erste Gruppe von Verstärkermodulen konfiguriert ist, um das erste Referenzsignal und Datensignale der ersten Gruppe von Datenleitungen (YIO1) zu empfangen und die Datensignale der ersten Gruppe von Datenleitungen (YIO1) zu verstärken, und wobei die zweite Gruppe von Verstärkermodulen konfiguriert ist, um das zweite Referenzsignal und Datensignale der zweiten Gruppe von Datenleitungen (YIO2) zu empfangen und die Datensignale der zweiten Gruppe von Datenleitungen (YIO2) zu verstärken.

15. Speicher nach Anspruch 14, wobei die erste Gruppe von Verstärkermodulen den Leseverstärkeranordnungen (4011) in den ungeraden Spalten entspricht und die zweite Gruppe von Verstärkermodulen den Leseverstärkeranordnungen (4012) in den geraden Spalten entspricht, und wobei die erste Gruppe von Verstärkermodulen eine gleiche erste Referenzdatenleitung (YIO#1) gemeinsam nutzen und die zweite Gruppe von Verstärkermodulen eine gleiche zweite Referenzdatenleitung (YIO#2) gemeinsam nutzen;
oder
wobei eine Hälfte der Vielzahl von zweiten Datenleitungen (YIO) auf einer Seite der ersten Referenzdatenleitung (YIO#1) und der zweiten Referenzdatenleitung (YIO#2) ist und die andere Hälfte der Vielzahl von zweiten Datenleitungen (YIO) auf der anderen Seite der ersten Referenzdatenleitung (YIO#1) und der zweiten Referenzdatenleitung (YIO#2) ist.

## Revendications

1. Circuit intégré à semi-conducteurs, appliqué à une mémoire comprenant un module de sélection de colonne (200) et une pluralité de cellules de mémoire, dans lequel chacune d'une ligne de bits (BL) et d'une ligne de bits complémentaire (BL#) est connectée à au moins une de la pluralité de cellules de mémoire, et le module de sélection de colonne (200) est connecté à la ligne de bits (BL) et à la ligne de bits complémentaire (BL#) pour effectuer une opération de lecture de données ou une opération d'écriture de données sur la cellule de mémoire ;
dans lequel le circuit intégré à semi-conducteurs comprend :
une première ligne de données (Ldat) connectée à la ligne de bits (BL) par l'intermédiaire du module de sélection de colonne (200), une première ligne de données complémentaire (Ldat#) connectée à la ligne de bits complémentaire (BL#) par l'intermédiaire du module de sélection de colonne (200), et une seconde ligne de données (YIO) ;
dans lequel
le circuit intégré à semi-conducteurs comprend en outre :
un module d'amplification local (15, 205) connecté entre la première ligne de données (Ldat) et la première ligne de données complémentaire (Ldat#) et configuré pour amplifier un signal de données de la première ligne de données et un signal de données de la première ligne de données complémentaire ;
un module de conversion de lecture-écriture local (201) comprenant une unité de lecture locale (311) et une unité d'écriture locale (312), dans lequel
l'unité de lecture locale (311) comprend un transistor de commande de lecture local (MN11) et un transistor de transmission de lecture local (MN21), une source du transistor de commande de lecture local (MN11) est mise à la terre, un drain du transistor de commande de lecture local (MN11) est connecté à une source du transistor de transmission de lecture locale (MN21), une grille du transistor de commande de lecture local (MN11) est configurée pour recevoir un signal de commande de lecture (Rd), un drain du transistor de transmission de lecture local (MN21) est connecté à la seconde ligne de données (YIO), et une grille du transistor de transmission de lecture local (MN21) est connectée à la première ligne de données complémentaire (Ldat#) ; et l'unité de lecture locale (311) est configurée pour transmettre, en réponse au signal de commande de lecture (Rd), un niveau d'un signal de données inversé de la première ligne de données complémentaire (Ldat#) à la seconde ligne de données (YIO) pendant l'opération de lecture de données ; et
l'unité d'écriture locale (312) comprend un transistor de commande d'écriture local (MN31), un second transistor de commande d'écriture local (MN41) et un transistor de transmission d'écriture local (MN51), un premier port du transistor de commande d'écriture local (MN31) est connecté à la seconde ligne de données (YIO) et un deuxième port du transistor de commande d'écriture locale (MN31) est connecté à la première ligne de données (Ldat) ; et l'unité d'écriture locale (312) est configurée pour transmettre, en réponse à un signal de commande d'écriture (Wr), un signal de données de la seconde ligne de données (YIO) à la première ligne de données (Ldat) pendant l'opération d'écriture de données par l'intermédiaire du transistor de commande d'écriture local (MN31), une grille du second transistor de commande d'écriture local (MN41) étant configurée pour recevoir le signal de commande d'écriture (Wr), un premier port du second transistor de commande d'écriture local (MN41) étant mis à la terre et un deuxième port du second transistor de commande d'écriture local (MN41) est connecté à un premier port du transistor de transmission d'écriture local (MN51), une grille du transistor de transmission d'écriture local (MN51) étant connectée à la seconde ligne de données (YIO), et un deuxième port du transistor de transmission d'écriture local (MN51) étant connecté à la première ligne de données complémentaire (Ldat#).

2. Circuit intégré à semi-conducteurs selon la revendication 1, comprenant en outre :
une ligne de données de référence (YIO#) configurée pour fournir un signal de référence (Ref) ; et
un module amplificateur (203) configuré pour recevoir le signal de données de la seconde ligne de données (YIO) et le signal de référence (Ref), amplifier le signal de données de la seconde ligne de données (YIO) et émettre le signal de données amplifié de la seconde ligne de données (YIO), dans lequel le signal de référence (Ref) sert de référence pour l'amplification du signal de données de la seconde ligne de données (YIO).

3. Circuit intégré à semi-conducteurs selon la revendication 2, dans lequel la ligne de données de référence (YIO#) a un potentiel de tension fixe.

4. Circuit intégré à semi-conducteurs selon la revendication 2, comprenant en outre :
un module de référence (202, 302) configuré pour émettre le signal de référence (Ref) sur la ligne de données de référence (YIO#) en réponse au signal de commande de lecture (Rd), dans lequel le module de référence (202, 302) a une capacité de décharge qui entraîne une diminution progressive d'un potentiel de tension du signal de référence (Ref) pendant l'opération de lecture des données.

5. Circuit intégré à semi-conducteurs selon la revendication 4, dans lequel, pendant l'opération de lecture des données, lorsque la seconde ligne de données (YIO) passe d'un premier niveau à un second niveau, le module de conversion de lecture-écriture local (201) a une première vitesse de décharge ; et pendant l'opération de lecture des données, le module de référence (202, 302) a une seconde vitesse de décharge, et la seconde vitesse de décharge est inférieure à la première vitesse de décharge.

6. Circuit intégré à semi-conducteurs selon la revendication 4, comprenant en outre :
une ligne de commande de référence (Co) configurée pour fournir un signal de commande de référence (cnt), dans lequel le module de référence (202, 302) est connecté à la ligne de commande de référence (Co) et émet le signal de référence (Ref) sur la ligne de données de référence (YIO#) en réponse au signal de commande de référence (cnt) et au signal de commande de lecture (Rd).

7. Circuit intégré à semi-conducteurs selon la revendication 6, dans lequel :
le module de référence (202, 302) comprend un premier port (A), un deuxième port (B), un troisième port (C) et un quatrième port (D) ;
le premier port (A) est configuré pour recevoir le signal de commande de lecture (Rd), le deuxième port (B) est configuré pour se connecter à la ligne de données de référence (YIO#), le troisième port (C) est configuré pour être mis à la terre et le quatrième port (D) est configuré pour recevoir le signal de commande de référence (cnt) ; et
le module de référence (202, 302) est configuré pour décharger, en réponse au signal de commande de référence (cnt) et au signal de commande de lecture (Rd), du deuxième port (B) vers le troisième port (C), afin de provoquer une diminution progressive du potentiel de tension de la ligne de données de référence (YIO#).

8. Circuit intégré à semi-conducteurs selon la revendication 7, dans lequel le module de référence (202, 302) comprend une première unité de commutation (211) et une seconde unité de commutation (212), dans lequel :
la première unité de commutation (211) est connectée entre le premier port (A) et le troisième port (C) et comprend un premier noeud (a), et la première unité de commutation (211) est configurée pour être activée en réponse au signal de commande de lecture (Rd) afin de former un chemin conducteur entre le premier noeud (a) et le troisième port (C) ; et
la seconde unité de commutation (212) est connectée entre le deuxième port (B) et le quatrième port (D) et comprend un second noeud (b) connecté au premier noeud (a), et la seconde unité de commutation (212) est configurée pour être activée en réponse au signal de commande de référence (cnt) afin de former un chemin conducteur entre le deuxième port (B) et le second noeud (b).

9. Circuit intégré à semi-conducteurs selon la revendication 7, dans lequel le module de référence (202, 302) comprend au moins un transistor de référence, et une conductivité de l'au moins un transistor de référence est plus faible qu'une conductivité du transistor de commande de lecture local (MN11) et qu'une conductivité du transistor de transmission de lecture local (MN21) ; et
dans lequel une largeur de canal de l'au moins un transistor de référence est inférieure aux largeurs de canal du transistor de commande de lecture local (MN11) et du transistor de transmission de lecture local (MN21).

10. Circuit intégré à semi-conducteurs selon la revendication 9, dans lequel le transistor de commande de lecture local (MN11) est configuré pour être activé en réponse au signal de commande de lecture (Rd) ; le transistor de transmission de lecture local (MN21) est configuré pour être activé en réponse au signal de données de la première ligne de données complémentaire (Ldat#), et la seconde ligne de données (YIO) est mise à la terre par l'intermédiaire du transistor de transmission de lecture local (MN21) et du transistor de commande de lecture local (MN11) ; et
l'au moins un transistor de référence comprend un transistor de commande de référence (MN12) configuré pour être activé en réponse au signal de commande de lecture (Rd), et la ligne de données de référence (YIO#) est mise à la terre par l'intermédiaire du transistor de commande de référence (MN12), dans lequel une largeur de canal du transistor de commande de référence (MN12) est inférieure à une largeur de canal du transistor de commande de lecture local (MN 11).

11. Circuit intégré à semi-conducteurs selon la revendication 10, dans lequel l'au moins un transistor de référence comprend en outre un transistor de transmission de référence (MN22) configuré pour être activé en réponse au signal de commande de référence (cnt), et la ligne de données de référence (YIO#) est mise à la terre par l'intermédiaire du transistor de commande de référence (MN12) et du transistor de transmission de référence (MN22), dans lequel une largeur de canal du transistor de transmission de référence (MN22) est inférieure à une largeur de canal du transistor de transmission de lecture local (MN21), de préférence, la largeur de canal du transistor de commande de référence (MN12) est inférieure ou égale à 2/3 de la largeur de canal du transistor de commande de lecture local (MN11), et la largeur de canal du transistor de transmission de référence (MN22) est inférieure ou égale à 2/3 de la largeur de canal du transistor de transmission de lecture local (MN21), de préférence encore, la largeur de canal du transistor de commande de référence (MN12) est égale à 1/2 de la largeur de canal du transistor de commande de lecture local (MN11), et la largeur de canal du transistor de transmission de référence (MN22) est égale à 1/2 de la largeur de canal du transistor de transmission de lecture local (MN21).

12. Circuit intégré à semi-conducteurs selon la revendication 4, dans lequel le module amplificateur (203) comprend un amplificateur différentiel, une première extrémité d'entrée de l'amplificateur différentiel est connectée à la seconde ligne de données (YIO) et une seconde extrémité d'entrée de l'amplificateur différentiel est connectée à la ligne de données de référence (YIO#).

13. Mémoire **caractérisée en ce qu'**elle comprend :
une pluralité de réseaux de cellules de mémoire (41) et une pluralité de réseaux d'amplificateurs de détection (42) disposés en alternance ; dans laquelle chacun de la pluralité de réseaux de cellules de mémoire (41) est connecté à au moins un de la pluralité de réseaux d'amplificateurs de détection (42) pour former un réseau de mémoires ; et
un circuit intégré à semi-conducteurs selon la revendication 1, dans laquelle chacune des premières lignes de données (Ldat) et chacune des premières lignes de données complémentaires (Ldat#) du circuit intégré à semi-conducteurs sont connectées à un réseau de cellules de mémoire (41) respectif par l'intermédiaire d'un réseau d'amplificateurs de détection (42) correspondant pour effectuer une opération de lecture de données ou une opération d'écriture de données sur le réseau de cellules de mémoire par l'intermédiaire d'un module de conversion de lecture-écriture local.

14. Mémoire selon la revendication 13, dans laquelle la pluralité de réseaux d'amplificateurs de détection (42) comprend :
une pluralité de premiers réseaux d'amplificateurs de détection (4011) disposés en colonnes impaires ; et
une pluralité de seconds réseaux d'amplificateurs de détection (4012) disposés en colonnes paires ;
une pluralité de secondes lignes de données (YIO) comprend un premier groupe de lignes de données (YIO1) correspondant à la pluralité de premiers réseaux d'amplificateurs de détection (4011) et un second groupe de lignes de données (YIO2) correspondant à la pluralité de seconds réseaux d'amplificateurs de détection (4012), dans lequel le premier groupe de lignes de données (YIO1) correspond aux premières lignes de données (Ldat) et aux premières lignes de données complémentaires (Ldat#) qui sont connectées à la pluralité de premiers réseaux d'amplificateurs de détection (4011), et le second groupe de lignes de données (YIO2) correspond aux premières lignes de données (Ldat) et aux premières lignes de données complémentaires (Ldat#) qui sont connectées à la pluralité de seconds réseaux d'amplificateurs de détection (4012) ;
une ligne de données de référence (YIO#) comprend une première ligne de données de référence (YIO#1) configurée pour fournir un premier signal de référence et une seconde ligne de données de référence (YIO#2) configurée pour fournir un second signal de référence ; et
un module amplificateur (403) comprend un premier groupe de modules amplificateurs et un second groupe de modules amplificateurs, dans lequel le premier groupe de modules amplificateurs est configuré pour recevoir le premier signal de référence et les signaux de données du premier groupe de lignes de données (YIO1) et amplifier les signaux de données du premier groupe de lignes de données (YIO1), et dans lequel le second groupe de modules amplificateurs est configuré pour recevoir le second signal de référence et les signaux de données du second groupe de lignes de données (YIO2) et amplifier les signaux de données du second groupe de lignes de données (YIO2).

15. Mémoire selon la revendication 14, dans laquelle le premier groupe de modules amplificateurs correspond aux réseaux d'amplificateurs de détection (4011) dans les colonnes impaires et le second groupe de modules amplificateurs correspond aux réseaux d'amplificateurs de détection (4012) dans les colonnes paires, et dans laquelle le premier groupe de modules amplificateurs partage une même première ligne de données de référence (YIO#1) et le second groupe de modules amplificateurs partage une même seconde ligne de données de référence (YIO#2) ;
ou
dans laquelle une moitié de la pluralité de secondes lignes de données (YIO) se trouve d'un côté de la première ligne de données de référence (YIO#1) et de la seconde ligne de données de référence (YIO#2), et l'autre moitié de la pluralité de secondes lignes de données (YIO) se trouve de l'autre côté de la première ligne de données de référence (YIO#1) et de la seconde ligne de données de référence (YIO#2).
